(19) Europäisches Patentamt
European Patent Office
Office européen des brevets

(11) Veröffentlichungsnummer : **0 021 019**
**B1**

(12) # EUROPÄISCHE PATENTSCHRIFT

(45) Veröffentlichungstag der Patentschrift : **17.10.84**

(51) Int. Cl.³ : **G 03 C 1/70**, C 08 L 33/00

(21) Anmeldenummer : **80102727.7**

(22) Anmeldetag : **16.05.80**

(54) **Lichtvernetzbare Copolymere, sie enthaltendes lichtempfindliches Aufzeichnungsmaterial, seine Verwendung zur Herstellung photographischer Abbildungen und Verfahren zur Herstellung von photographischen Abbildungen.**

(30) Priorität : **18.05.79 CH 4673/79**

(43) Veröffentlichungstag der Anmeldung : **07.01.81 Patentblatt 81/01**

(45) Bekanntmachung des Hinweises auf die Patenterteilung : **17.10.84 Patentblatt 84/42**

(84) Benannte Vertragsstaaten : **AT BE CH DE FR GB IT LI**

(56) Entgegenhaltungen :
**DE-A- 2 437 422**
**DE-B- 2 135 482**
**Die Akte enthält technische Angaben, die nach dem Eingang der Anmeldung eingereicht wurden und die nicht in dieser Patentschrift enthalten sind.**

(73) Patentinhaber : **CIBA-GEIGY AG**
**Postfach**
**CH-4002 Basel (CH)**

(72) Erfinder : **Roth, Martin, Dr.**
**Chemin des Epinettes 12**
**CH-1723 Marly (CH)**
Erfinder : **Müller, Beat, Dr.**
**imp. de la Colline 3**
**CH-1723 Marly (CH)**
Erfinder : **Berger, Joseph, Dr.**
**Rte des Préalpes 4**
**CH-1723 Marly (CH)**
Erfinder : **Loew, Peter, Dr.**
**Concordiastrasse 23**
**CH-4142 Münchenstein (CH)**

(74) Vertreter : **Berg, Wilhelm, Dr. et al**
**Patentanwälte Dr. Berg Dipl.-Ing. Stapf Dipl.-Ing. Schwabe Dr. Dr. Sandmair Postfach 86 02 45 Stuntzstrasse 16**
**D-8000 München 86 (DE)**

**EP 0 021 019 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

## Beschreibung

Die vorliegende Erfindung betrifft lichtvernetzbare Copolymere, ein lichtempfindliches Aufzeichnungsmaterial, das auf einem Träger eine Schicht mit mindestens einem lichtvernetzbaren Polymer enthält, dessen Seitenketten lichtaktive Maleinimidgruppierungen aufweisen, sowie ein vereinfachtes Verarbeitungsverfahren zur Herstellung eingefärbter photographischer Polymer-bilder.

Aus der DE-A-2 626 769 sind bereits vernetzbare polymere Verbindungen bekannt, die lichtaktive Maleinimidgruppierungen in den Seitenketten enthalten, und zur Herstellung von Polymerbildern durch bildmässige Belichtung geeignet sind. Nach der Belichtung werden dabei die unvernetzten Anteile mit einem Lösungsmittel herausgelöst und das Bild durch eine nachfolgende Behandlung mit einem in einem Lösungsmittel gelösten Farbstoff angefärbt. Diese stufenweise Berstellung der Polymerbilder weist verschiedene Nachteile auf. So erfolgt in der Regel zwischen dem Auswaschen und Einfärben eine Aenderung des Quellgrades des vernetzten Polymers, was einerseits zu einer Verminderung der Bildqualität führt und andererseits die Haftung des Polymerbildes auf dem Träger erheblich beeinträchtigen kann, indem es zur teilweisen oder vollständigen Ablösung des Polymerbildes kommen kann. Ein weiterer Nachteil ist der erhebliche Zeitaufwand, den die stufenweise Herstellung der Polymerbilder erfordert.

Aufgabe der vorliegenden Erfindung ist es nun, ein neues vereinfachtes Verfahren zur Herstellung von Polymerbildern, welches eine kurze Verarbeitungszeit und nur wenige Verarbeitungsschritte erfordert und dem Anwender trotzdem weiten Spielraum in Bezug auf Wahl der Farbe und optischen Dichte des Bildes und damit der Applikation des Bildmaterials lässt, sowie auch neue lichtvernetzbare Copolymere und neue lichtempfindliche Aufzeichnungsmaterialien zur Herstellung von Polymerbildern bereitzustellen, die aufgrund ihrer Zusamensetzung die Verarbeitung nach dem vereinfachten Verfahren erlauben und zu Polymerbildern mit hoher optischer Dichte und guter Auflösung führen.

Es wurde nun gefunden, dass man die gestellten Aufgaben erfindungsgemäss lösen kann, wenn man bildmässig belichtete (und damit vernetzte) Photopolymere mit bestimmten Anteilen an sauren oder basischen Gruppen beim Entwickeln mit wässrigen oder wässrigorganischen, alkalisch oder sauer reagierenden, Farbstoff enthaltenden Lösungen behandelt, anschliessend auswäscht und trocknet.

Gegenstand der vorliegenden Erfindung ist damit ein lichtempfindliches Aufzeichnungsmaterial, das auf einem Träger eine Schicht aus mindestens einem lichtvernetzbaren Copolymer mit einem durchschnittlichen Molekulargewicht von $10^3$ bis $10^6$ enthält, dessen Seitenketten lichtaktive Maleinimidgruppierungen aufweisen, wobei das Copolymer

(1) mindestens 10 Gewichtsprozent, bezogen auf die Gesamtmenge der Comonomeren eines (Meth)acrylsäureester-, (Meth)acrylsäureamid- oder Vinylätherderivates, das mindestens eine Maleinimidgruppe der Formel

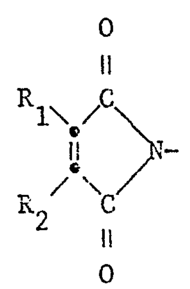

(1)

enthält, worin $R_1$ und $R_2$ je Alkyl mit 1 bis 4 Kohlenstoffatomen sind oder $R_1$ und $R_2$ zusammen mit den Kohlenstoffatomen, mit denen sie verbunden sind, einen 5- oder 6-gliedrigen carbocyclischen Ring bilden, und

(2) eines saure Gruppen aufweisenden, äthylenisch ungesättigten Comonomer aus der Gruppe Acrylsäure, Methacrylsäure, Crotonsäure, Maleinsäure, Fumarsäure, Itaconsäure, 2-Sulfoäthylmethacrylat, Vinylsulfonsäure und deren Salze, Styrolsulfonsäure oder ein Phthalsäure-(meth)acrylathalbester, und gegebenenfalls

(3) mindestens ein weiteres, äthylenisch ungesättigtes Comonomer, das von den Comonomeren (1) und (2) verschieden ist, enthält, das

dadurch gekennzeichnet ist, dass das Comonomer (2) in einer Menge von mindestens 18 Gew.-%, bezogen auf die Gesamtmenge der Comonomeren, zugegen ist.

Gegenstand der Erfindung ist ferner das lichtvernetzbare Copolymer, das sich im genannten erfindungsgemässen Aufzeichnungsmaterial befindet, sowie ein erstes Verfahren zur Herstellung von

photographischen Abbildungen unter Verwendung eines erfindungsgemässen Aufzeichnungsmaterials, indem man dieses nach seiner bildmässigen Belichtung mit einer alkalischen, wässrigen oder wässrig-organischen Lösung, die einen kationischen Farbstoff enthält, entwickelt, anschliessend auswäscht und trocknet.

Ein weiterer Gegenstand der Erfindung ist ein zweites Verfahren zur Herstellung von photographischen Abbildungen unter Verwendung eines lichtempfindlichen Aufzeichnungsmaterials, das auf einem Träger lichtvernetzbare Copolymere mit einem durchschnittlichen Molekulargewicht von $10^3$ bis $10^6$ enthält, deren Seitenketten lichtaktive Maleinimidgruppierungen aufweisen, wobei das Copolymer

(1) mindestens 10 Gew.-%, bezogen auf die Gesamtmenge der Comonomeren, eines Acrylsäure- oder Methacrylsäureesters, Acrylsäure- oder Methacrylsäureamides oder Vinylätherderivates, das mindestens eine Maleinimidgruppe der Formel

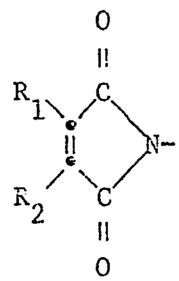

enthält, worin $R_1$ und $R_2$ je Alkyl mit 1 bis 4 Kohlenstoffatomen sind oder $R_1$ und $R_2$ zusammen mit den Kohlenstoffatomen, mit denen sie verbunden sind, einen 5- oder 6-gliedrigen carbocyclischen Ring bilden,

(2) mindestens 18 Gew.-%, bezogen auf die Gesamtmenge der Comonomeren, eines Dialkylaminogruppen tragenden Carbonsäurederivates einer α,β-ungesättigten Carbonsäure oder einer stickstoffheterocyclischen Vinylverbindung, und gegebenenfalls

(3) mindestens ein weiteres, äthylenisch ungesättigtes Comonomer, das von (1) und (2) verschieden ist, enthält,

dadurch gekennzeichnet, dass man das bildmässig belichtete Material mit einer sauren, wässrigen oder wässrig-organischen Lösung, die einen anionischen Farbstoff enthält, entwickelt, anschliessend auswäscht und trocknet.

Ein weiterer Gegenstand der Erfindung ist ein drittes Verfahren zur Herstellung von photographischen Abbildungen unter Verwendung eines lichtempfindlichen Aufzeichnungsmaterials, das auf einem Träger lichtvernetzbare, Carboxylgruppen enthaltende Copolymere mit einem durchschnittlichen Molekulargewicht von $10^3$ bis $10^6$ aus mindestens 10 Gew.-% Maleinsäureanhydrid, bezogen auf die Gesamtmenge der Comonomeren, und α,β-ungesättigten Comonomeren enthält, wobei die Seitenketten der Copolymere lichtaktive Maleinimidgruppierungen der Formel

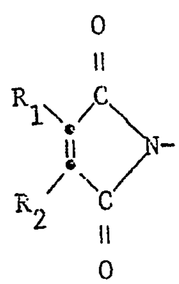

enthalten, worin $R_1$ und $R_2$ je Alkyl mit bis zu 4 Kohlenstoffatomen sind oder $R_1$ und $R_2$ zusammen mit den Kohlenstoffatomen, mit denen sie verbunden sind, einen 5- oder 6-gleidrigen carbocyclischen Ring bilden, dadurch gekennzeichnet, dass man das bildmässig belichtete Material mit einer alkalischen, wässrigen oder wässrigorganischen Lösung, die einen kationischen Farbstoff enthält, entwickelt, anschliessend auswäscht und trocknet.

Folgende, unter dem Einfluss elektromagnetischer Wellen vernetzbare Copolymere sind zur Herstellung des erfindungsgemässen Aufzeichnungsmaterials bzw. zur Herstellung von photographischen Abbildungen gemäss dem erfindungsgemässen ersten Verfahren geeignet :

(A) Copolymerisate von reaktiven C = C-Doppelbindungen enthaltenden Monomeren mit Durchschnittsmolekulargewichten zwischen $10^3$ und $10^6$, welche die Maleinimidgruppen der Formel (1) in Molekülkettengliedern der Formeln

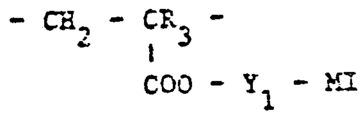

(2)

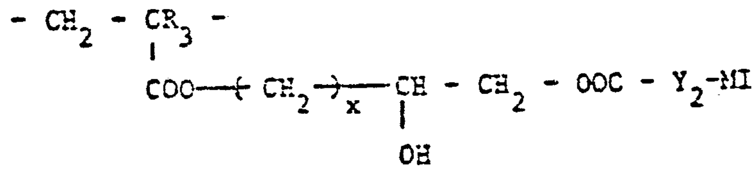

(x = 1 oder 2) (3)

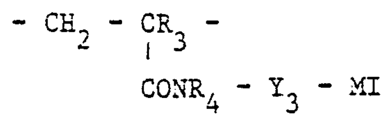

(4)

oder

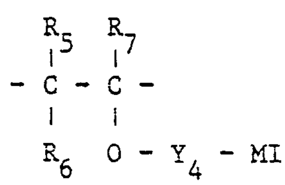

(5)

enthalten, worin

MI die Maleinimidgruppe der Formel (1) und

$Y_2$ ein aliphatisches, cycloaliphatisches, carbocyclisch-aromatisches, araliphatisches, heterocyclisch-aliphatisches oder heterocyclisch-aromatisches Brückenglied mit jeweils insgesamt höchstens 18 Kohlenstoffatomen ist,

$Y_1$ dieselbe Definition wie $Y_2$ hat oder die Gruppierung der Formel

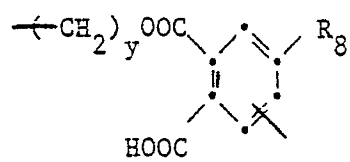

(y = 1 bis 4) (6)

ist,

$Y_3$ dieselbe Definition wie $Y_2$ hat oder die Gruppierung —CO—$Y_2$ ist,

$Y_4$ dieselbe Definition wie $Y_2$ hat oder vorzugsweise ein aliphatischer oder carbocyclisch-aromatischer Rest ist,

$R_3$ Wasserstoff oder Alkyl, vorzugsweise Methyl,

$R_4$ Wasserstoff oder Alkyl mit 1 bis 6 Kohlenstoffatomen,

$R_5$, $R_6$ und $R_7$ unabhängig voneinander Wasserstoff, Halogen, Cyano, Alkyl, Aryl, Aralkyl, vorzugsweise jedoch Wasserstoff sind

und

$R_8$ Wasserstoff, —COOH oder —$COO(CH_2)_zCH_3$ (z = 0 bis 18) ist.

Zu den angegebenen chemischen Formeln ist grundsätzlich folgendes festzustellen: Werden zweiwertige, durch ein Symbol (z. B. « Y ») charakterisierte Molekülreste, welche Teile einer Grundformel darstellen, durch weitere Formeln näher erläutert, so werden diese zweiwertigen Reste räumlich immer so angeführt, dass sie ohne Drehung in die Grundformel eingebaut werden können. Die Rechts-Links-Anordnungen sowohl der Grundformel als auch der Formel des jeweiligen näher erläuterten, zweiwertigen Molekülrestes sind also unverändert zu lassen.

Bevorzugte Comonomere (1) entsprechen den Formeln

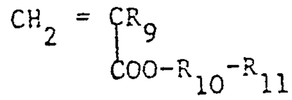 , (7)

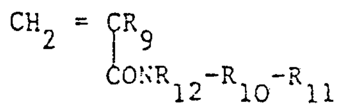 oder (8)

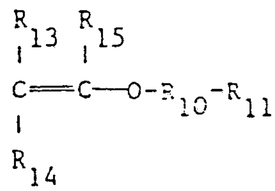 (9)

worin

$R_9$ Wasserstoff oder Methyl, $R_{10}$ geradkettiges oder verzweigtes Alkylen mit 1 bis 12 Kohlenstoffatomen oder Cycloalkylen mit 5 oder 6 Kohlenstoffatomen, $R_{11}$ eine Maleinimidgruppierung der Formel

(10) 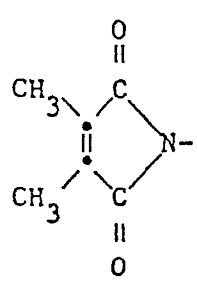 , (11) 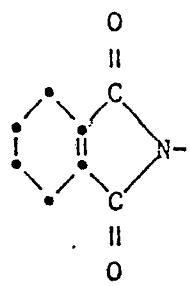 oder (12) 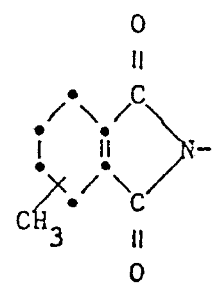

und $R_{12}$ Wasserstoff oder Alkyl mit 1 bis 6 Kohlenstoffatomen ist und $R_{13}$, $R_{14}$ und $R_{15}$ je Wasserstoff, Halogen, Cyano oder Alkyl mit 1 bis 6 Kohlenstoffatomen sind.

Die Comonomeren der Formeln (7) und (9) sind bevorzugt, wobei die Comonomeren der Formel (7) besonders geeignet sind, so z. B. die Verbindungen der Formel

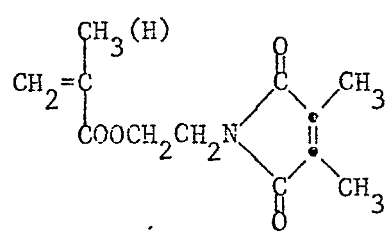 (13)

Der Gehalt an diesem Monomer bestimmt die Vernetzungsdichte des unter Lichteinwirkung entstehenden Netzwerkes. Ist er zu klein, so ist die Vernetzung und damit die mechanische Festigkeit der Schicht unzureichend.

Ausser den soeben beschriebenen Maleinimidgruppen enthaltenden Molekülkettengliedern, die 10 bis 82 Gew.-% des Copolymeren ausmachen können, weisen die Copolymeren des Typs (A) maleinimidgruppenfreie Molekülkettenglieder auf, die saure Gruppen sowie gegebenenfalls zusätzlich weitere maleinimidgruppenfreie Kettenglieder enthalten. Die sauren Kettenglieder leiten sich von den folgenden Comonomeren (2) ab : Acrylsäure, Methacrylsäure, Maleinsäure, Fumarsäure, Itaconsäure, Crotonsäure, Vinylsulfonsäure und deren Salze (z. B. Na- oder K-Salz), 2-Sulfoäthyl-methacrylat, Styrol-sulfonsäure

oder Phthalsäure(meth)acrylsäure halbester, die sich aus der Umsetzung von Phthalsäureanhydrid mit 1 Mol Hydroxyäthyl(meth)acrylat ergeben.

Die eventuell zu verwendenden zusätzlichen Kettenglieder (Comonomer (3)) (ohne saure Gruppen) leiten sich von den folgenden Comonomeren ab :

Olefine, insbesondere Alkene, Vinylhalogenide, beispielsweise Vinylchlorid, Vinylbromid, Vinylfluorid ; Vinylidene, beispielsweise Vinylidenchlorid ; Nitrile α,β-ungesättigter Säuren, beispielsweise (Meth)acrylnitril ; Ester α,β-ungesättigter Säuren, (Acryl- und Methacrylsäure), beispielsweise Methylmethacrylat, Aethylacrylat, Propylacrylat, Butylacrylat, Octylacrylat, 2-Aethyl-hexyl-acrylat, Methylmethacrylat, Aethylmethacrylat, Isopropylmethacrylat, Butylmethacrylat, Glycidylacrylat, Glycidylmethacrylat, Chlormethylmethacrylat ; α,β-ungesättigte Carbonsäureamide und ihre Derivate, beispielsweise Acrylamid, Methacrylamid ; aromatische Vinylverbindungen, beispielsweise Styrol, Methylstyrol, Vinyltoluol, α-Chlorstyrol ; Vinylketone, beispielsweise Methylvinylketon ; Vinylester, beispielsweise Vinylacetat ; heterocyclische Vinylverbindungen, beispielsweise Vinylpyrrolidon, Vinylcarbazol oder ein Vinyläther.

Die Copolymeren können 0 bis 72 Gew.-% von wiederkehrenden Einheiten enthalten, die sich von den Comonomeren (3) ableiten.

Die Herstellung der Copolymeren (A) ist in der DE-A-2 626 769, die Herstellung der maleinimidgruppenhaltigen Monomeren in der DE-A-2 626 795 beschrieben.

Bevorzugte Copolymere (A) sind solche, die aus Comonomeren (2) mit freien Carboxylgruppen hergestellt sind, wie insbesondere α,β-ungesättigte Säuren, wie Methacrylsäure, Acrylsäure, Maleinsäure (Maleinsäureanhydrid) und Phthalsäure-mono-β-methacryloxi-äthylester. Die erhaltenen Polymeren sind in wässrig alkalischen Lösungen löslich.

Dabei kann der Gehalt an diesen Säuren im Polymeren zwischen 18 und 50 Gew.-% variieren, bevorzugt zwischen 20 und 40 Gew.-%. Die Einstellung eines optimalen Gehalts an Carboxylgruppen tragenden Kettengliedern wird im wesentlichen durch die Zusammensetzung und das Molekulargewicht der Copolymeren sowie durch die Zusammensetzung der Entwicklerlösung (pH-Wert, Farbstoffe) bestimmt. Die Menge der Carboxylgruppen soll so gross sein, dass das unvernetzte Polymere in der Entwicklerlösung löslich ist oder zumindest gequollen wird. Wird sie aber zu gross, dann quillt das Reliefbild während dem Entwicklungsvorgang zu stark auf was zu einer Verminderung der Haftung auf dem Schichtträger und einer eventuellen Ablösung führen kann.

Ausserdem ermöglichen die Carboxylgruppen die Anfärbung der durch aktinisches Licht bildmässig vernetzten Bildstellen mit kationischen Farbstoffen. Die maximal erreichbare Farbdichte des Bildes hängt demzufolge unter anderem vom Carboxylgruppengehalt der Copolymeren ab.

Für die Herstellung der bevorzugten Copolymeren des Typs (A) kommen bevorzugt die folgenden Radikalpolymerisationsverfahren in Betracht

a) Polymerisation in Lösung
b) Fällungspolymerisation
c) Emulsionspolymerisation.

Die Copolymeren können nach üblichen bekannten Verfahren gereinigt werden, beispielsweise durch Ausfällen in einem Nichtlösemittel für das Copolymer und anschliessendem Waschen und Trocknen.

Die nach a) und c) anfallenden Reaktionsprodukte (bei a) : Lösung des Copolymers, bei c) : Copolymerlatex) können aber auch in bevorzugter Weise nach eventuellem Verdünnen und Zusetzen von Hilfsstoffen, wie z. B. Sensibilisatoren, direkt auf den Träger geschichtet werden.

Für das erfindungsgemäss zweite Verfahren zur Herstellung von photographischen Abbildungen unter Verwendung von Aufzeichnungsmaterialien, die lichtvernetzbare Copolymere mit Maleinimidseitenketten und basischen Gruppen enthalten sind Copolymere des Typs (A) geeignet, die an Stelle der Molekülkettenglieder mit sauren Gruppen solche mit basischen Gruppen enthalten. Besonders geeignet sind solche Copolymere, in die die basischen Gruppen unter Verwendung von Dialkylaminogruppen tragenden Carbonsäurederivaten α,β-ungesättiger Carbonsäuren oder stickstoffheterocyclischen Vinylverbindungen als Comonomere in das Copolymer eingeführt werden. Als basische Comonomere kommen z. B. in Betracht : Comonomere aus der Reihe der Vinylpyridinverbindungen, z. B. 2-Vinylpyridin, 4-Vinylpyridin, basisch substituierte (Dialkylaminogruppen tragende) Acylester oder Amide, beispielsweise Dimethylaminoäthyl(meth)-acrylat, Diäthylaminoäther(meth)-acrylat, Dimethylaminopropyl(meth)-acrylat, Diäthylaminopropyl(meth)-acrylat, Dimethylaminopropylmethacrylamid oder Diäthylaminopropylmethacrylamid.

Für das erfindungsgemässe dritte Verfahren zur Herstellung von photographischen Abbildungen unter Verwendung von Aufzeichnungsmaterialien, die Copolymere mit sauren Gruppen enthalten, sind besonders

(B) Copolymere von reaktiven C = C-Doppelbindungen enthaltenden Monomeren mit Durchschnittsmolekulargewichten zwischen $10^3$ und $10^6$ geeignet, die die Maleinimidgruppen der Formel (1) in Molekülkettengliedern der Formeln

```
-CH - CH -
 |     |                          (14)
COOH COO-Y5-MI        oder
```

```
-CH - CH -
 |     |                          (15)
COOH CONR9-(Y6)q-MI
```

enthalten, worin $Y_5$ ein aliphatischer, cycloaliphatischer, carbocyclisch-aromatischer, araliphatischer, heterocyclisch-aliphatischer oder heterocyclisch-aromatischer Rest mit jeweils insgesamt höchstens 18 Kohlenstoffatomen oder die Gruppierung der Formel $-CH_2CH(OH)(CH_2)_n-$, $Y_6$ ein aliphatischer, cycloaliphatischer, carbocyclisch-aromatischer, araliphatischer, heterocyclisch-aliphatischer oder heterocyclisch-aromatischer Rest mit jeweils insgesamt höchstens 18 Kohlenstoffatomen, $q = 0$ oder 1, $R_9$ Wasserstoff oder Alkyl mit 1 bis 6 Kohlenstoffatomen und MI die Maleinimidgruppe der Formel (1) ist.

Besonders geeignet sind für das dritte Verfahren Copolymere aus Maleinsäureanhydrid und α,β-ungesättigten Comonomeren (z. B. die weiter oben genannten Comonomeren (2) und (3)), wobei die Seitenketten dieser Copolymeren die Maleinimidgruppierungen der Formel (1) enthalten, insbesondere in Form der zuvor angegebenen Molekülkettenglieder (14) und (15). Der Gehalt an Säuregruppen enthaltenden bzw. Säuregruppen bildenden (Maleinsäureanhydrid-Oeffnung des Anhydridringes durch chemische Umsetzung) Comonomeren im Copolymer kann in der Regel 10 bis 90, insbesondere bis 50 Gew.-% betragen.

Die Lichtempfindlichkeit der erfindungsgemässen Copolymeren wird durch Sensibilisatoren ganz erheblich erhöht. Durch geeignete Wahl von Sensibilisatoren lässt sich die Empfindlichkeit auf das Licht diverser handelsüblichen Kopierlampen, wie z. B. Metall-Halogenlampen, maximal anpassen.

Als Sensibilisatoren sind insbesondere Triplettsensibilisatoren geeignet, bei deren Anwendung die Vernetzung durch Triplettenergietransfer des angeregten Sensibilisators auf den nicht angeregten Maleinsäureimidrest der Formel (1) erfolgt : vergleiche dazu N.J. Turro, « Mol. Photochemistry », W.A. Benjamin Inc. [1965], Seite 107. Die beiden Bedingungen für eine wirksame Sensibilisierung sind die folgenden :

1. Der Triplettsensibilisator muss ein Absorptionsmaximum aufweisen, das eine praktisch ausreichende Lichtabsorption im Bereich von mehr als 300 nm erlaubt.
2. Der Triplettenergietransfer muss exotherm sein. Es kommen beispielsweise die folgenden Sensibilisatoren in Betracht :

Benzol, Phenol, Benzoesäure, Benzonitril, Anilin, Xanthon, Acetophenon, Diisopropylketon, Diphenylsulfid, Diphenylamin, Benzaldehyd, Diphenylselen, Carbazol, Triphenylamin, Hexachlorbenzol, 4,4-Diphenylctyclohexadienon, 1,2-Dibenzoylbenzol, Thiophen, Benzophenon, 1,4-Diacetylbenzol, Fluoren, Triphenylen, 4-Cyanobenzophenon, Diphenyl, Thioxanthon (auch halogensubstituiert), Phenylglyoxal, Anthrachinon, Chinolin, Phenanthren, Flavon, Michlers Keton, Naphthalin, 4-Acetyldiphenyl, Nitrobenzol, 2-Acetonaphthen, Acridingelb, 1-Naphthylphenylketon, Chrysen, 1-Acetonaphthol, 1-Naphthaldehyd, Diacetyl, Coronen, Benzil, Fluorenon, Fluorescein (Säure), p-Nitrostilben, Anthron, Benzanthron, 2-Nitrofluoren, gegebenenfalls substituiertes Chinoxalin, 4-Nitrodiphenyl, 5-Nitroacenaphthen, 4-Nitroanilin, Naphthothiazolin, 1-Acetylamino-4-nitronaphthalin.

Durch die Einführung von Elementen mit hohem Atomgewicht, z. B. Jod oder Brom, kann die Triplettausbeute und damit die Empfindlichkeit erhöht werden.

Speziell gut geeignet für Kopierlicht von 400-420 nm (Metall-Halogen) sind substituierte Thioxanthone, wie beispielsweise Alkylester des 6-Carboxi-2-methyl-thioxanthons. Die Sensibilisatoren werden bevorzugt in Mengen von 0,1-10 Gew.-% bezogen auf das Gewicht des Copolymers eingesetzt. Es können auch Kombinationen von mehreren, verschiedenen Sensibilisatoren eingesetzt werden.

Als Schichtträger können die üblichen bekannten Schichtträger verwendet werden, deren Verwendung zur Herstellung photographischer Materialien des erfindungsgemässen Typs bekannt ist. Bevorzugt verwendet werden Folien aus Poly(äthylenterephthalat), Celluloseacetat, Celluloseacetatpropionat, Celluloseacetatbutyrat, Polyäthylen oder Polypropylen. Ausserdem können faserförmige Stoffe Verwendung finden, z. B. Papiere, die gegebenenfalls mit Polyäthylen und/oder Polypropylen beschichtet sind ; ausserdem können Träger aus Glas und Metallen, z. B. Aluminium, Kupfer, Magnesium oder Zink infrage kommen.

Die erfindungsgemässen photographischen Materialien können nach üblichen bekannten Beschichtungsverfahren hergestellt werden.

In der Regel werden dabei die Copolymere in organischen Lösungsmitteln gelöst und auf die Trägermaterialien aufgetragen.

Die im Einzelfalle günstigste Schichtdicke der aufgetragenen Schicht hängt von dem Verwendungszweck des hergestellten Materials ab. Bevorzugte Schichtdicken liegen im Bereich von 0,5-15 μm.

Zur Belichtung des vorliegenden Materials sind solche Lichtquellen geeignet, die im Bereich der Absorptionsbande des Sensibilisators eine wirksame Menge Strahlung abgeben. Da viele der genannten Sensibilisatoren zwischen 300 nm und 450 nm Absorption aufweisen, werden Lichtquellen bevorzugt, die in diesem Bereich einen hohen Strahlungsanteil emittieren. Es sind sowohl Punktlichtquellen als auch flächenförmige Strahler (Lampenteppiche) geeignet. Beispiele sind : Kohlelichtbogenlampen, Xenon-Lichtbogenlampen, Quecksilberdampflampen- gegebenenfalls mit Metall-Halogenid dotiert (Metall-Halogenlampen), Fluoreszenzlampen mit UV-Licht abstrahlenden Leuchtstoffen, Argonglühlampen, Elektronenblitzlampen und photographische Flutlichtlampen. Der Abstand zwischen Lampe und erfindungsgemässen Bildmaterial kann je nach Anwendungszweck und Lampentyp bzw. -stärke variieren, z. B. zwischen 2 cm bis 150 cm. In gewissen Fällen kann es vorteilhaft sein, mit sichtbarem Licht unter Verwendung eines Photoinitiators, der im sichtbaren Bereich des Spektrums empfindlich ist, zu belichten. In solchen Fällen sollte die Strahlungsquelle eine wirksame Menge sichtbaren Lichts abstrahlen.

Viele der vorstehend genannten Lichtquellen liefern die erforderliche Menge an sichtbarem Licht. Es ist auch möglich, die Polymeren ohne Sensibilisator bildmässig zu vernetzen. Dazu sind Lichtquellen erforderlich, die im Bereich der Absorptionsbanden der Maleinimidgruppen der Formel (1) Licht emittieren, d. h. zwischen ca. 200-350 nm. Geeignet sind beispielsweise Quecksilberniederdruck- oder -mitteldruckdampflampen.

Die Verarbeitung des belichteten Materials zum fertigen Bild sollte möglichst einfach sein und ohne Emission von gefährlichen chemischen Schadstoffen, wie z. B. gewissen flüchtigen Lösungsmitteln, vorsichgehen. Um dem Anwender einen breiten Spielraum zu lassen, sollte Handverarbeitung und Maschinenverarbeitung (Prozessor) mit dem gleichen Bildmaterial und den gleichen Entwicklerlösungen möglich sein. Um dem Material eine grosse Anwendungsbreite zu geben (z. B. als Kontaktmaske für die Belichtung von Druckformen und als Mikrofilm) sollte die Einfärbung des Reliefs während des Entwicklungsvorgangs stattfinden, da dann der Anwender die Farbe und Farbstärke des Bildes mit dem gleichen Bildmaterial sehr einfach durch entsprechende Wahl der Entwicklerlösung bestimmen kann, d. h. mit einem Filmmaterial können wahlweise beliebige monochrome Bilder erzeugt werden.

Die genannten Anforderungen an den Verarbeitungsprozess werden durch die erfindungsgemässen Verfahren erfüllt.

Das lichtvernetzbare Polymermaterial wird durch eine Vorlage mit aktinischer Strahlung belichtet, wobei die lichtempfindliche Schicht bildmässig vernetzt. Beim Entwickeln wird diese mit einer wässrigen, alkalisch, neutral oder sauer reagierenden, Farbstoff enthaltenden Lösung behandelt. Die Lösung diffundiert in die lichtempfindliche, bildmässig vernetzte Schicht hinein, wobei sie je nach Entwicklungszeit die ganze Schicht (bis zum Träger) oder nur einen Teil der Schicht durchdringt. Bereits jetzt können sich die unvernetzten Bildteile, die mit der Lösung in Kontakt kommen (d. h. innerhalb der Entwicklerfront), weglösen, spätestens aber bei der nachfolgenden Wässerung. Zusätzlich werden die mit der Lösung in Kontakt gekommenen Bildstellen mit dem Farbstoff eingefärbt.

Anschliessend wird mit Wasser gespült um überschüssigen Farbstoff und die unvernetzten Bildteile wegzuwaschen. Es verbleibt ein gefärbtes Reliefbild, wobei das Relief bis zum Träger ausgewaschen ist oder aber bei kürzeren Einwirkungszeiten der Entwicklerlösung nicht bis zum Träger ausgewaschen ist und in diesem Fall auf einer dünnen Schicht photovernetzbarem Polymeren, die nicht angefärbt ist, aufliegt. Bei diesem letzteren Fall ist dadurch eine wesentlich bessere Adhäsion des Reliefs im feuchten, gequollenen Zustand zum Trägermaterial gegeben, was sich in einer verbesserten mechanischen Festigkeit des Materials und damit einer besseren Handhabung ausdrückt.

Durch den kombinierten Einsatz von Lösungsmittel (wässriges Alkali oder wässrige Säure) und Farbstoff in der gleichen Lösung wird die Verarbeitungszeit erheblich herabgesetzt und vereinfacht. Ausserdem findet keine Aenderung des Quellungsgrades zwischen Auswaschen und Einfärben statt, die bei den bisher üblichen Methoden zu einer Verminderung der Bildqualität (Abbildungstreue) führte.

Neben dem beschrieben Aufnahmematerial (Polymere mit sauren oder basischen Gruppen) spielt die Zusammensetzung der Entwicklerlösung wie angegeben eine wichtige Rolle. Sie besteht im wesentlichen aus einer wässrigen Base oder Säure (oder neutrales Wasser) in der kationische oder anionische Farbstoffe gelöst sind, sowie gegebenenfalls Hilfsstoffe wie beispielsweise Netzmittel, Stabilisatoren und wasserlösliche organische Lösungsmittel. Als Basen eignen sich beispielsweise die Alkalimetallhydroxide, wie Lithium-, Natrium- und Kaliumhydroxid, die basisch reagierenden Alkalisalze von schwachen Säuren wie Lithium-, Natrium- und Kaliumcarbonat und -bicarbonat, Ammoniumhydroxid und trialkylsubstituierte Ammoniumhydroxide, wie Triäthylammonium-, Tributylammonium-, Trishydroxiäthylammoniumhydroxid, tetrasubstituierte Ammoniumhydroxide, wie Tetramethyl-, Tetraäthyl-, Trimethylbenzyl- und Trimethylphenylammoniumhydroxid, Sulfoniumhydroxide, wie Trimethyl-, Diäthylmethyl-, Dimethylbenzylsulfoniumhydroxid und ihre löslichen, basischen Salze z. B. Carbonate, Bicarbonate und Sulfide, Alkaliphosphate und -pyrophosphate, z. B. Natrium- und Kaliumtriphosphat und Natrium- und Kaliumpyrophosphate, tetrasubstituiertes (vorzugsweise vollständig alkylsubstituiertes) Phosphonium-, Arsonium- und Stiboniumhydroxid, wie Tetramethylphosphoniumhydroxid, Alkaliborate, wie Lithium-, Natrium- oder Kaliumtetraborat.

Als Säuren eignen sich Mineralsäuren, wie Schwefel- Salz- und Salpetersäure, organische Carbonsäuren, wie Essigsäure, Maleinsäure, Weinsäure oder Citronensäure oder organische Sulfonsäuren, wie p-Toluolsulfonsäure.

Die Wahl der geeigneten Base oder Säure richtet sich nach der Zusammensetzung der photovernetzbaren Schicht und nach den in der gleichen Lösung vorhandenen Farbstoffen. In gewissem Mass ist auch die Einstellung einer gewünschten optischen Dichte des Bildes durch geeignete Wahl des pH-Wertes der Lösung möglich. Die bevorzugten Konzentrationen der Basen oder Säuren in der wässrigen Lösung liegen im Bereich von 0,01-20 Gew.%.

Für die zusammen mit der Base oder Säure in der gleichen Lösung vorliegenden Farbstoffe kommen kationische oder anionische Farbstoffe in Betracht. Aus der grossen Zahl der möglichen Verbindungen sind diejenigen geeignet, die sich im basischen oder sauren Entwickler in ausreichender Konzentration lösen und in dieser Lösung eine ausreichende Zeit stabil sind. Es können einzelne Farbstoffe oder Gemische verwendet werden. Bevorzugte Konzentrationen liegen im Bereich von 0,01-10 Gew.% bezogen auf Entwicklerlösung. Durch Variation dieser Farbstoffkonzentrationen lässt sich die optische Dichte des eingefärbten Bildes ändern. Die Farbstoffkonzentration beeinflusst die Löslichkeit der photovernetzbaren Polymerschicht im Entwickler in der Weise, dass zu hohe Konzentration zur Unlöslichkeit des Polymeren führen kann.

Das Einhalten eines gewissen Konzentrationsbereiches ist deshalb wichtig. Die Absorptionsbanden der Farbstoffe können im Bereich von 300 bis 800 nm liegen. Durch Auswahl geeigneter Farbstoffkombinationen lassen sich beliebige Bereiche innerhalb des Spektrums abdecken.

Die Wahl dieser Bereiche richtet sich nach der Anwendung des vorliegenden Bildmaterials. Für eine Anwendung als Kontaktfilm zum Belichten von Druckformen ist zum Beispiel eine hohe optische Dichte im Bereich 350 bis 450 nm notwendig. Für die Anwendung als Mikrofilmkopie kann z. B. eine mittlere optische Dichte erwünscht sein.

Für saure Gruppen enthaltende Polymere werden in der Regel kationische Farbstoffe, für basische Gruppen enthaltende Polymere in der Regel anionische Farbstoffe verwendet. Die Farbstoffe können den verschiedensten chemischen Klassen angehören ; beispielsweise handelt es sich bei den kationischen Farbstoffen um Azofarbstoffe, wie Monoazo-, Disazo- und Polyazofarbstoffe, Anthrachinonfarbstoffe, Phthalocyaninfarbstoffe, Diphenylmethan- und Triarylmethanfarbstoffe, Naphtholactam-, Methin-, Polymethin- und Azomethinfarbstoffe, Enamin-, Hydrazon-, Thiazol-, Ketonimin-, Acridin-, Cyanin-, Nitro-, Chinolin-, Benzimidazol-, Xanthen-, Azin- und Thiazinfarbstoffe. Bevorzugte kationische Farbstoffe sind Azo-, Anthrachinon-, Azacyanin- und Oxazinfarbstoffe.

Bevorzugte anionische Farbstoffe sind beispielsweise Mono-, Dis- und Polyazofarbstoffe sowie Anthrachinonfarbstoffe.

Farbstoffe der folgenden Formeln können z. B. verwendet werden :

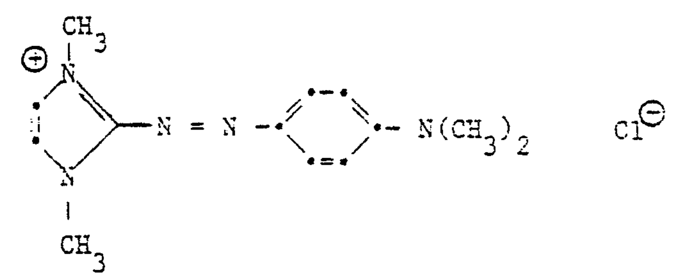

(16)

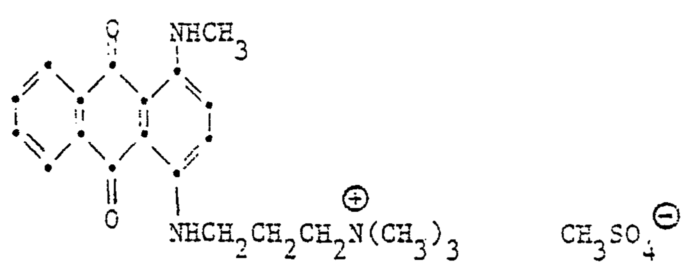

(17)

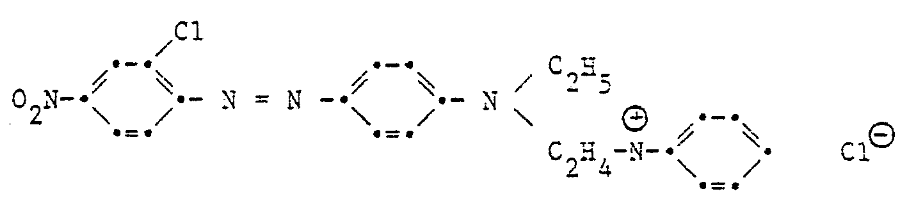

(18)

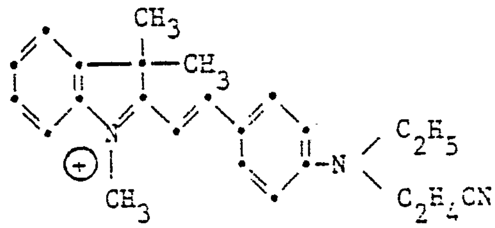

$Cl^{\ominus}$ (19)

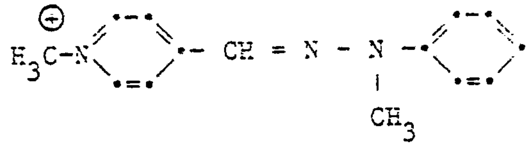

$CH_3SO_4^{\ominus}$ (20)

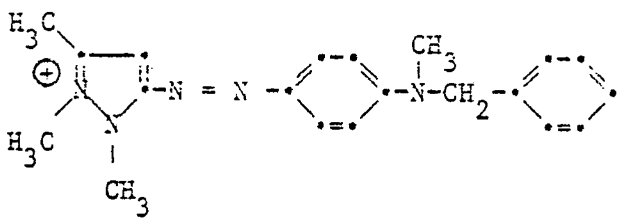

$CH_3SO_4^{\ominus}$ (21)

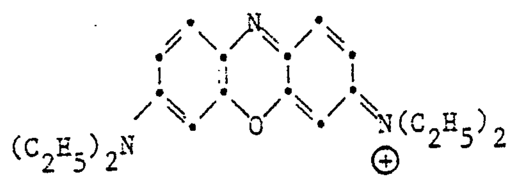

$ZnCl_3^{\ominus}$ (22)

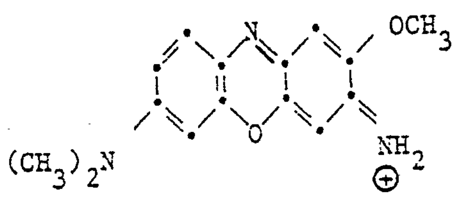

$Cl^{\ominus}$ (23)

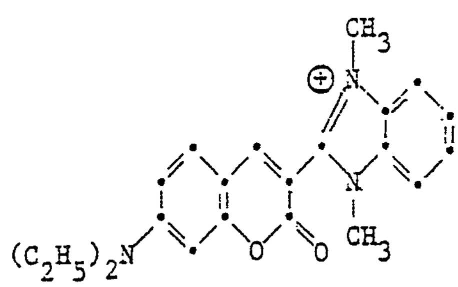

$CH_3SO_4^{\ominus}$ (24)

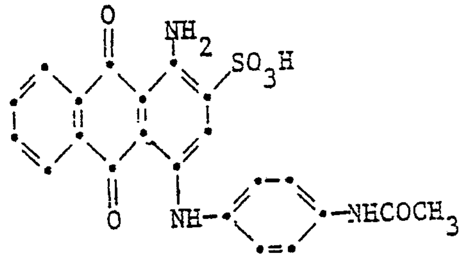

(25)

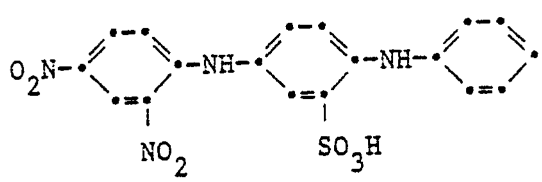

(26)

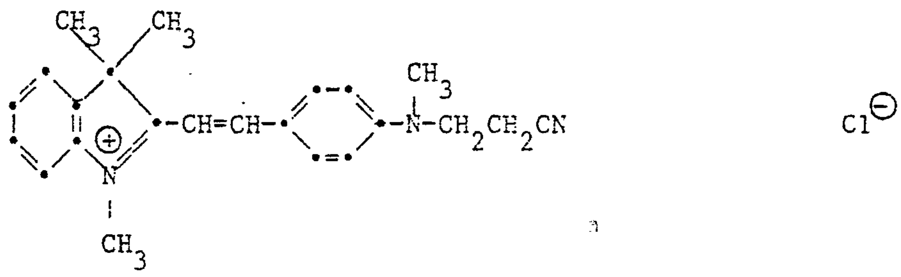 (27)

Zusätzlich kann die Entwicklerlösung wasserlösliche, organische Lösungsmittel enthalten. Diese organischen Lösungsmittel können die Löslichkeit der unvernetzten Schichtstellen im Entwickler verbessern und/oder zu einer besseren Löslichkeit der Farbstoffe in der Entwicklerlösung beitragen. Der Gehalt an solchen Lösungsmitteln kann zwischen 0,1 und 80 Gew.% betragen. Geeignet sind beispielsweise Alkohole, wie Methanol, Aethanol, Butanol ; Glykole, wie Aethylenglykol, Diäthylenglykol ; Glykoläther, wie Dioxan, Dimethoxiäthan, Diäthylenglykoldiäthyläther, Diäthylenglykoldibutyläther ; Ketone, wie Aceton, Methyläthylketon und Amide wie Dimethylformamid.

Daneben können dem Entwickler zur besseren Benetzung noch oberflächenaktive Netzmittel beigefügt werden.

Anwendungsmöglichkeiten für die erfindungsgemässen Materialien und Verfahren sind z. B. Kontaktfilme (Kontakmasken) zum Belichten von Druckformen, wie z. B. lithographische Druckplatten oder Buchdruckplatten ; ferner zur Klischeeherstellung, Zeichenfilme für das graphische und kartographische Gewerbe, beispielsweise für die Reproduktion von Ingenieurarbeiten, Plänen oder Schaltungen, für die Herstellung von Mikrofilmkopien (hohes Auflösungsvermögen der beschriebenen Aufzeichnungsmaterialien). Speziell geeignet ist das Material auch für das Kopieren von auf Silberhalogenidfilm (« Master ») aufgezeichneten Computerdaten (COM). Die Silberhalogenidfilme können dabei schwarze Zeichen oder Buchstaben auf transparentem Hintergrund enthalten, d. h. sie müssen nicht in einer langdauernden und komplizierten Umkehrentwicklung verarbeitet werden. Die Kopie auf das erfindungsgemässe Material besteht dann aus transparenten Charakteren auf farbigem Hintergrund.

Ausserdem findet das Material Verwendung zur Hertellung von farbigen Transparenten, z. B. für Werbezwecke, ferner in Farbprüfverfahren.

In den nachfolgenden Beispielen beziehen sich Teile und Prozente auf das Gewicht, sofern nicht anders angegeben.

Abkürzungsverzeichnis

DMI-MA 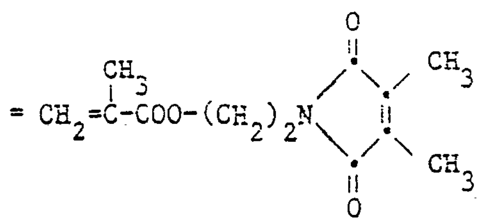

(Dimethylmaleinimidoäthylmethacrylat)

DMIA 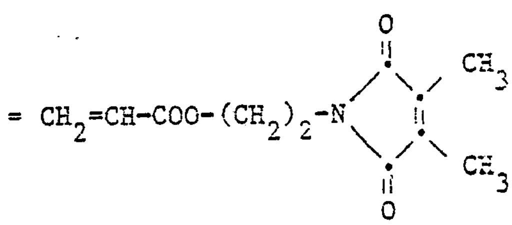

(Dimethylmaleinimidoäthylacrylat)

AS = Acrylsäure
MAS = Methylacrylsäure
MEK = Methyl-äthylketon

MCS = Methylcellosolve (Aethylenglykolmonomethyläther)
AIBN = α,α-Azo-bis-isobutyronitril
inh. V. = inhärente Viskosität einer 0,5 % Lösung in MEK/MCS 1 : 1 bei 25 °C
AeA = Aethylacrylat
MMA = Methylmethacrylat
DC = Dodecylmercaptan
BuMA = Butylmethacrylat
VC = Vinylidenchlorid
TX = Thioxanthon
MPS = Mercaptopropionsäure
4VP = 4-Vinylpyridin.

Beispiel 1

Copolymer aus :

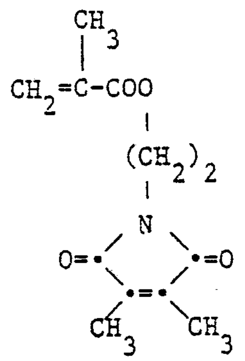
(DMI-MA) +
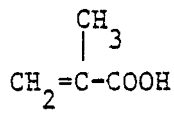
(MAS)

[Monomerverhältnis 80 : 20 Gew.%]

In einem 3 000 ml-Reaktor mit mechanischer Rührung, Stickstoffein- und -ausleitung und Tropftrichter mit Druckausgleich wird die folgende Mischung vorgelegt :

300 g Dimethylmaleinimidoäthyl-methacrylat (stabilisiert mit 0,05 % Di-tert. butyl-p-kresol),
75 g Methacrylsäure (frisch destilliert),
2 080 g Lösungsmittelgemisch Methyläthylketon/Methylcellosolve 1 : 1 (V/V).

Der Tropftrichter wird mit der Lösung von 2,25 g Azo-bis-isobutyronitril (AIBN) in 45 g Methyläthylketon/Methylcellosolve 1 : 1 beschickt.

Nach dem Inertisieren mit Stickstoff lässt man aus dem Tropftrichter 1/3 der Initiatorlösung zulaufen und thermostatisiert den Reaktor auf 65 °C Innentemperatur. Man hält unter Rühren total 22 Stunden bei 65 °C, wobei das zweite Drittel Initiatorlösung nach 4 Stunden und das letzte Drittel nach weiteren 4 Stunden zugegeben werden.

Eine Probe der viskosen, farblosen Polymerlösung wird in Aether gefällt, das feste Polymer abfiltriert und getrocknet. Man bestimmt eine Polymerausbeute von 95,2 % sowie eine inhärente Viskosität von 0,204 dl/g (0,5 % Lösung in MEK/MCS 1 : 1, 25 °C).

Die etwa 15 %ige Polymerlösung kann direkt zur Beschichtung verwendet werden.

Beispiel 2

Copolymer aus : DMI-MA + MAS [70 : 30 Gew.%]

Nach dem Verfahren gemäss Beispiel 1 werden

49,0 g DMI-MA, 21,0 g MAS,
385,0 g Methyläthylketon/Methycellosolve 5 : 1 (V/V) und
0,420 g AIBN in 10 g MEK/MCS 5 : 1 (V/V) polymerisiert.

Die Polymerausbeute ist nach 22 Stunden bei 65 °C quantitativ. Inh. Viskosität = 0,238 dl/g (0,5 % IN MEK/MCS 1 : 1, 25 °C).

Die etwa 15 %ige Polymerlösung wird direkt zur Beschichtung verwendet.

Beispiel 3

Copolymer aus : DMI-MA + MAS + Aethylacrylat (AeA) [60 : 20 : 20 Gew.%]
Nach dem Verfahren gemäss Beispiel 1 werden

52,5 g DMI-MA, 17,5 g MAS,
17,5 g AeA (destabilisiert),
485,0 g Methyläthylketon/Methylcellosolve 20 : 1 (V/V) und
0,525 g AIBN in 10 Ml MEK/MCS (20 : 1) polymerisiert.

Polymerausbeute nach 22 Stunden bei 65 °C : 88 % Inh. Viskosität = 0,248 dl/g (0,5 % in MEK/MCS 1 : 1, 25 °C).
Die etwa 15 %ige Polymerlösung wird direkt zur Beschichtung verwendet.

Beispiel 4

Copolymer aus : DMI-MA + MAS + Methylmethacrylat (MMA) [60 : 25 : 15 Gew.%]
Nach dem Verfahren gemäss Beispiel 1 werden

42,0 g DMI-MA, 17,5 g MAS, 10,5 g MMA (destabilisiert),
385,0 g Methyläthylketon/Methylcellosolve 5 : 1 (V/V) und
0,420 g AIBN in 10 g MEK/MCS 5 : 1 polymerisiert.

Polymerausbeute nach 22 Stunden bei 65 °C : 96 % Inh. Viskosität = 0,200 dl/g (0,5 % in MEK/MCS 1 : 1, 25 °C).
Die etwa 15 % ige Polymerlösung wird direkt zur Beschichtung verwendet.

Beispiel 5

Herstellung der Verbindung der Formel

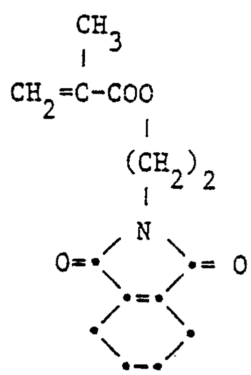

142,5 g (0,94 Mol) Δ-1-Tetrahydrophthalsäureanhydrid und 57,2 g (0,94 Mol) Aethanolamin werden zusammen auf 130 °C erhitzt und das sich bildende Wasser durch Anlegen eines schwachen Vakuums abdestilliert.

Nach 1 Stunde bei 130 °C wird das Reaktionsprodukt im Vakuum destilliert. Man gewinnt 169 g (92 % d. Th) N-β-hydroxyäthyl-Tetrahydrophthalsäureimid. Siedepunkt 135-152 °C/0,001 mm Schmelzpunkt : 48-51 °C.

97,60 g N-β-hydroxiäthyl-Δ-1-Tetrahydrophthalsäureimid,
125,15 g Methylmethacrylat,
3,0 g Hydrochinon und
4,0 ml conc. Schwefelsäure werden

an einer isolierten (Vakuummantel, verspiegelt) Vigreuxkolonne von 50 cm Länge mit Kolonnenkopf auf 110-120 °C (Badtemp.) erhitzt wobei das sich bildende Methanol-Methylmethacrylat-Azeotrop (Siedepunkt ca. 62-65°) kontinuierlich abgetrennt wird. Nach dem Nachlassen der Methanolbildung wird das Reaktionsprodukt unter Zusatz von etwas Natriumcarbonat (Neutralisation der Schwefelsäure) am Vakuum fraktionierend destilliert, Man erhält 97 g (66 % d. Th.) öliges Δ-1-Tetrahydrophthalimidoäthylmethacrylat, Siedepunkt 145-151 °C 0,2 mm IR ($CHCl_3$) : 1 710 $cm^{-1}$.

## Beispiel 6

Copolymer aus :

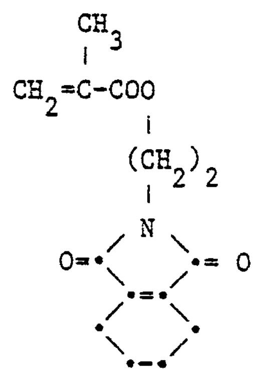

+ MAS [75 : 25 Gew.%]

5,63 g Δ-1-Tetrahydrophthalimidoäthyl-methacrylat (destabilisiert),
1,88 g MAS,
42,50 g Methyläthylketon/Methylcellosolve 1 : 1 (V/V) und
0,045 g AIBN werden

in einer Ampulle unter Stickstoff 22 Stunden bei 65 °C polymerisiert. Man fällt in Aether, wobei 6,12 g (82 % Ausbeute) festes, farbloses Polymer mit der inh. Viskosität 0,142 dl/g (0,5 % in MEK/MCS 1 : 1, 25 °C) erhalten werden.

## Beispiel 7

Herstellung von

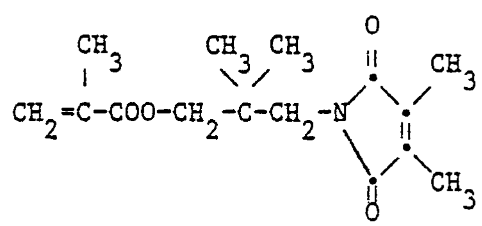

504 g (4,0 Mol) Dimethylmaleinsäureanhydrid und 408 g (4,0 Mol) Neopentanolamin werden in 1 000 ml Xylol am Wasserabscheider erhitzt (Bad 140 °C). Nach 2 1/2 Stunden haben sich ca. 70 ml Wasser abgeschieden. Man entfernt das Xylol am Rotationsverdampfer und destilliert den Rückstand im Vakuum. Man erhält 810 g (96 % d. Th.) Neopentanolimid Siedepunkt : 105-107 °C/0,001 mm ; Schmelzpunkt 54-55 °C 211,3 g Neopentanolimid, 250,0 g Methylmethacrylat, 6,0 g Hydrochinon und 8,0 ml conc. Schwefelsäure werden nach dem Verfahren gemäss Beispiel 5 erhitzt und das Methanol-Methylmethacrylat-Azeotrop kontinuierlich abgetrennt. Der Rückstand wird im Vakuum fraktionierend destilliert. Man erhält 228 g (82 % d. Th.) Neopentanolimidester. Siedepunkt : 130-143 °C/0,001 mm ; Schmelzpunkt : 64-74 °C.

## Beispiel 8

Copolymer aus :

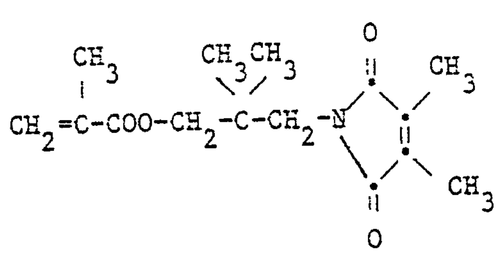

+ MAS [80 : 20 Gew.%]

Nach dem Verfahren gemäss Beispiel 1 werden

300 g Neopentanolesterimid (Beispiel 7), destabilisiert;
75 g MAS, 2 080g Methyläthylketon/Methylcellosolve 1 : 1 (V/V) und
2,25 g AIBN in 45 g MEK/MCS 1 : 1 polymerisiert.

Die Polymerausbeute nach 22 Stunden bei 65 °C ist quantitativ; inhärente Viskosität = 0,25 dl/g (0,5 % in MEK/MCS 1 : 1, 25 °C).

## Beispiel 9

Copolymer aus:

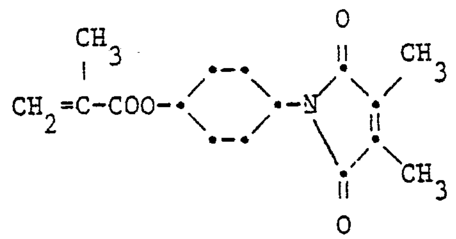

+ MAS [75 : 25 Gew.%]

Nach dem Verfahren gemäss Beispiel 1 werden

9,4 g Cyclohexanolimidester, 3,1 g MAS,
60,0 g Methyläthylketon/Methylcellosolve 1 : 1 (V/V) und 0,075 mg AIBN in 10,5 g MEK/MCS 1 : 1 polymerisiert. Polymerausbeute nach 29 Stunden bei 65 °C: 94 %; inh. Viskosität: 0,205 dl/g (0,5 % in MEK/MCS 1 : 1, 25 °C).
Die etwa 15 %ige Polymerlösung wird direkt zur Beschichtung verwendet.

## Beispiel 10

Copolymer aus:

DMI-MA + 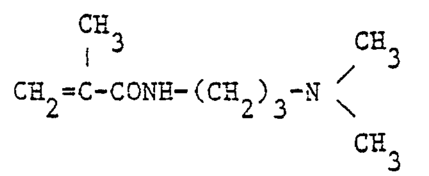 [10 : 5 Gew.%]

10,0 g DMI-MA,
5,0 g Dimethylaminopropylmethacrylamid und 0,075 g AIBN in
100 ml Toluol

werden in einer Ampulle unter Stickstoff 24 Stunden bei 65 °C polymerisiert. Man fällt in Aether, wobei 14,0 g farbloses, festes Polymer erhalten werden. Ausbeute: 93 % d. Th.

## Beispiel 11

9,6 g DMI-MA,
2,4 g MAS, 120 mg DC und 60 mg AIBN wurden in 48 g trockenem Toluol gelöst und in einem 250 ml Sulfierungskolben, versehen mit Stickstoff-Einleitung, Rührer, Rückflusskühler und Thermometer bei 60 °C 41 Stunden polymerisiert. Das entstehende Polymer fällt nach Erreichung eines kritischen Molekulargewichtes in Form eines freien Pulvers aus.
Das Fällungsgut wird abfiltriert und im Vakuum bei einer Temperatur unter 100 °C getrocknet.
Polymer-Umsatz 89 %, inh. V. = 0,24 dl/g (in (MEK) (MCS) = 1 : 1), Polymer-DMI-MA-Gehalt 71.1 %.

## Beispiel 12

4,8 g der Verbindung der Formel

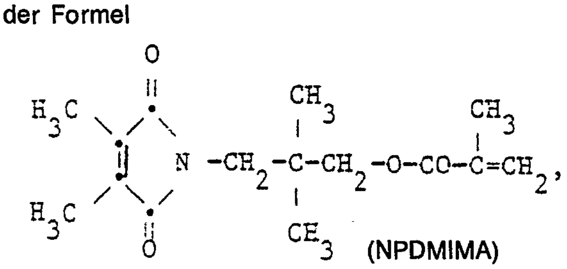

(NPDMIMA)

1,2 g MAS, 60 mg DC und 30 mg AIBN werden in 24 g trockenem Toluol wie im Beispiel 11 angegeben polymerisiert. Polymer-Umsatz 69 % ; inh. V. = 0,22 dl/g. Polymer-DMI-Gehalt 67,7 %.

Beispiel 13

4,0 g DMIMA, 4,0 g NPDMIMA, 2,0 MAS, 100 mg DC und 50 mg AIBN werden in 40 g trockenem Toluol 24 Stunden bei 60 °C wie im Beispiel 11 angegeben polymerisiert, Polymer-Umsatz : 77,0 % ; inh. V. = 0,25 dl/g, Polymer-DIM-Gehalt 57,3 %.

Beispiel 14

135,0 g DMIMA, 45,0 g Butylmethacrylat (BuMA), 2,25 g DC und 1,7 g AIBN werden in 900 g trockenem Toluol 44 Stunden bei 60 °C wie im Beispiel 11 angegeben polymerisiert.
Polymer-Umsatz : 80,0 % ; inh. V. = 0,29 dl/g, Polymer-DMI-MA-Gehalt 55,8 %.

Beispiel 15

90,0 g DMIMA, 45,0 g BuMA, 45,0 g Vinylidenchlorid (VC), 45,0 g MAS, 1,01 g AIBN und 1,35 g DC werden in 900 g trockenem Toluol 16 Stunden bei 60 °C und anschliessend 24 Stunden bei 70 °C wie im Beispiel 11 angegeben polymerisiert.
Polymer-Umsatz : 73 % ; inh. V. = 0,33 dl/g. Polymer-DMI-MA-Gehalt 40,6 %, Polymer-VC-Gehalt 10,3 %.

Beispiel 16

37,5 g DMIMA, 18,8 g BuMA, 18,8 g MAS, 750 mg AIBN und 1,13 g DC werden in trockenem Toluol 6 Stunden bei 80 °C wie im Beispiel 11 angegeben polymerisiert.
Polymer-Umsatz : 74,4 % ; inh. V. = 0,20 dl/g, Polymer-DMI-MA-Gehalt : 44,0 %.

Beispiel 17

45,0 DMIMA, 15,0 g BuMA, 15,0 g MAS, 750 mg AIBN und 1,13 g DC werden in 212,5 g Toluol 24 Stunden bei 80 °C so polymerisiert (vgl. Beispiel 11), dass man nach 5,5 Stunden Reaktionsdauer eine zweite Portion 750 mg AIBN und 1,13 g DC zugibt.
Umsatz : 65,0 % inh. V. = 0,19 dl/g, Polymer-DMI-MA-Gehalt : 57,5 %.

Beispiel 18

7,5 g Verbindung der Formel

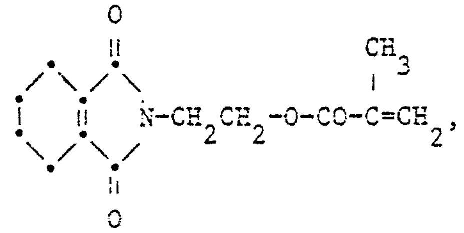

2,5 g MAS und 60 mg AIBN werden in 40 g trockenem Toluol 24 Stunden bei 80 °C wie im Beispiel 11 angegeben polymerisiert.
Polymer-Umsatz : 76,5 %.

Beispiel 19

6,0 g DMIMA, 2,0 g 2-Hydroxyäthylacrylat, 2,0 g MAS, 70 mg AIBN und 100 mg DC werden in 40 g trockenem Toluol 24 Stunden bei 80 °C wie im Beispiel 11 angegeben polymerisiert.
Polymer-Umsatz : 69,2 %.

Beispiel 20

10,0 g DMIMA, 2,5 g Acrylsäure (AS) und 62,5 mg AIBN werden in 112,5 g MEK/MCS = 1 : 1 gelöst. Ein ampullenartiges Gefäss, versehen mit Anschluss an Hochvakuum und Stickstoff-Zufuhr, wird mit der Polymerisationslösung gefüllt. Aus dem Gefäss wird Sauerstoff entfernt, und dann die Polymerisation bei 60 °C während 24 Stunden im Vakuum durchgeführt.

Das Polymere wird in Aether gefällt und im Vakuum getrocknet.
Polymer-Umsatz : 68,8 % ; inh. V. = 0,14 dl/g, Polymer-DMI-MA-Gehalt : 81,8 %.

Beispiel 21

Polymerisationsansatz : 8,75 g DMI-MA, 3,75 g AS, 62,5 mg AIBN, 50 g MEK/MCS (1 : 1) Polymerisationsdurchführung : wie im Beispiel 11.
Polymer-Umsatz 75,2 %, inh. V. = 0,21 dl/g, Polymer-DMI-MA-Gehalt : 76,1 %.

Beispiel 22

In einem 250 ml Sulfierkolben, der mit Stickstoffeinleitung, Rührer und Thermometer ausgestattet ist, werden 28,3 ml Wasser und 68,3 mg Kaliumpersulfat vorgelegt. Die Lösung wird 30 Minuten mit Stickstoff durchgespült, dann werden bei 25 °C während 2 Stunden die folgenden Lösungen gleichzeitig zudosiert :

a) 21,2 g DMIMA, 6,4 g AS und 11,9 g Aethacrylat (EA)
b) 46,7 ml $H_2O$, 1 ml einer 3,95 %igen Ascorbinsäurelösung und 2,4 ml einer 0,14 %igen Eisensulfatlösung
c) 28,3 ml $H_2O$ und 6,5 ml einer 26,7 %igen Lösung von Nonylphenol-polyäthyllenglykolammoniumsulfat.

Die Reaktionslösung lässt man nach Beendigung der Zudosierung noch 2 Stunden unter Stickstoff nachreagieren. Der entstandene Latex ist stabil ; die Teilchengrösse beträgt 0,04 ± 0,02 μm. Der Latex ist zur direkten Beschichtung von Polyesterfilm geeignet.

Beispiel 23

Polymer aus : 18,4 g DMIMA, 17,0 g DMIA, 1,4 g AS, 2,7 g Methylmethacrylat (MMA) und 0,8 g Thioxanthon (TX) hergestellt nach dem Verfahren gemäss Beispiel 11.

Beispiel 24

Polymer aus : 18,4 g DMIMA, 17,0 g DMIA, 1,4 g AS, 2,7 g MMA und 0,40 g 3-Mercaptopropionsäure (MPS), hergestellt nach dem Verfahren gemäss Beispiel 11.

Beispiel 25

5,0 g DMIMA, 5,0 g 4-Vinylpyridin (4VP) und 50 mg AIBN werden in 40 g Lösungsmittelgemisch MEK/MCS 1 : 1 bei 60 °C 24 Stunden unter Stickstoff polymerisiert. Die Lösung wird direkt zur Beschichtung verwendet.
Polymer-Umsatz : 89 % (gefällt in Petroläther).

Beispiel 26

5,0 g DMIMA, 5,0 g 4VP und 50 mg AIBN werden in 40 g trockenem Toluol bei 80 °C 24 Stunden unter Stickstoff polymerisiert. Das ausgefallene Polymer wird abfiltriert und im Vakuum getrocknet.
Polymer-Umsatz : 95 %.

Beispiel 27

Latexpolymerisation eines Copolymers aus :

DMI-MA +

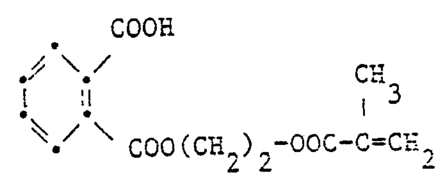

Monomerverhältnis 33 : 66 Gew.%

In einem geschlossenen thermostatisierten Reaktor mit Rührer, Thermometer und zwei Tropftrichtern werden vorgelegt : 400 ml Wasser, 2 g $K_2S_2O_8$, 0,5 g Dodecylmercaptan, 3 g Nonylphenolpolyathylenglykolammoniumsulfat (60 % in Aethanol) und 8 ml $FeSO_4$-Lösung (0,15 %). Zur vorgelegten Lösung werden in separaten Tropftrichtern die Monomermischung und der Aktivator während 3 Stunden zugegeben. Die Monomermischung besteht aus 100 g DMI-MA und 200 g Phthalsäuremono-β-methacryloxiäthylester als 50 %ige Lösung in Essigsäureäthylester. Als Aktivator wird eine Lösung von 2 g $Na_2S_2O_5$ in 300 ml Wasser verwendet. Die Apparatur wird dreimal evakuiert und mit Stickstoff gespült. Kurz nach Beginn der Zugabe der beiden Komponenten wird die Lösung bläulich. Die Temperatur wird auf 20 °C gehalten. Nach beendeter Zugabe (3 Std.) wird die Lösung noch 1 Stunde weitergerührt und anschliessend von geringen Mengen Bodenkörper durch einen Gelatinefilter abgetrennt.

Der Latex kann durch Zugabe von NaCl-Lösung gebrochen werden ; das Polymer wird abgenutscht, mit Aether gewaschen und getrocknet.

Ausbeute 95 %.

Inhärente Viskosität : 0,145 dl/g.

Beispiel 28

Lösungspolymerisation ; Copolymer aus :

DMI-MA + 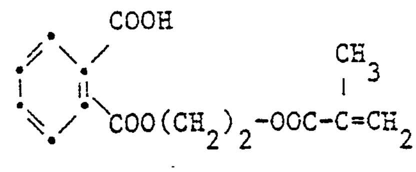 50 : 50 Gew.%

In einem geschlossenen thermostatisierten 1-Liter-Reaktor mit Thermometer und Tropftrichter werden 75 g DMI-MA, 75 g Phthalsäure-mono-β-methacryloxiäthylester und 700 ml einer 1 : 1 Mischung von Methyläthylketon und Methylcellosolve gelöst. Die Apparatur wird 4 mal evakuiert und mit Stickstoff gespült. Die Polymerisation erfolgt bei 60 °C unter leichtem Stickstoffüberdruck. Zu Beginn und nach je 5 Stunden wird 1/3 der AIBN-Lösung (0,9 g AIBN in 10 ml Lösungsmittelgemisch) aus dem Tropftrichter zugegeben. Nach 24 Stunden Reaktionszeit ist die Polymerisation beendet. Ausbeute : 98 %, inhärente Viskosität : 0,187 dl/g.

Beispiel 29

8,7 g der Verbindung der Formel

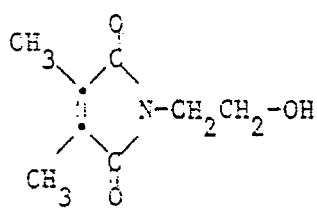 (DMI-OH)

und 6,3 g eines alternierenden niedermolekularen Aethylen-Maleinsäureanhydrid Copolymeren (EMA 1103) werden in 40 ml Tetrahydrofuran gelöst und unter Feuchtigkeitsausschluss während 48 Stunden am Rückfluss erhitzt. Das Polymer wird durch Fällen in Aether isoliert und im Vakuum getrocknet. Aus der Elementaranalyse (C 55,01 % ; H 6,36 % ; N 1,84 %) kann man auf 38 %igen Umsatz der Anhydridgruppen schliessen.

Beispiel 30

45 g DMI-MA, 15 g BuMA, 25 g MAS, 15 g 2-Aethylhexylmethacrylat (ÄHMA), 1 g AIBN und 0,5 g DC werden in 500 g trockenem Toluol wie im Beispiel 11 angegeben polymerisiert. Polymer-Umsatz : 63 % ; inhärente Viskosität : 0,27 g dl/g. Polymer-DMI-Gehalt 42,3 %.

Beispiel 31

13,3 g 2-Dimethylmaleinimidyl-äthylvinyläther (DMI-VA), 6,7 g Maleinsäureanhydrid, 100 mg AIBN und 1 g MPS werden in 113,3 g trockenem Benzol wie im Beispiel 11 angegeben polymerisiert. Das entstandene Polymer wird in 1 000 ml Aether gefällt. Das Fällungsgut wird abfiltriert und im Valuum bei einer Temperatur unter 100 °C getrocknet. Polymerumsatz : 75,5 % ; inhärente Viskosität : 0,21 dl/g ; Polymer-DMI-VA-Gehalt 63,7 %.

Beispiel 32

5,7 g DMI-VA, 9,3 g N,N-Dimethylamino-2-äthylmethacrylat [DMAEMA) und 30 mg AIBN werden in

85 g trockenem Benzol wie im Beispiel 11 angegeben 100 Stunden bei 60 °C polymerisiert. Das entstandene Polymer wird in 700 ml Aether gefällt. Das Fällungsgut wird abfiltriert und im Vakuum getrocknet. Polymer-Umsatz : 92 % ; inhärente Viskosität : 0,28 dl/g.

Beispiel 33

Zu einer Mischung von 10 g DMI-MA, 10 g DMAEMA, 12 g Dimethylsulfat und 80 mg DC, die in einem 250 ml Sulfrierungskolben in 75 g Isopropanol gelöst ist, wird 300 mg AIBN, gelöst in 20 g MCS, zugegeben. Die Polymerisation wird bei 80 °C 2 Stunden unter Stickstoff geführt. Nach nochmaliger Zugabe von 200 mg AIBN in 20 ml MCS wird die Mischung weitere 2 Stunden polymerisiert. Das ausgefallene Polymer wird abfiltriert und im Vakuum getrocknet. Polymer-Ausbeute : 95 % ; inhärente Viskosität : 1,10 dl/g.

Beispiel 34

Handbeschichtung eines photografischen Trägers. Zu der etwa 15 %igen Polymerlösung gemäss Beispiel 1, werden 5 % (bezogen auf das Gewicht des festen Polymers) des Sensibilisators der Formel

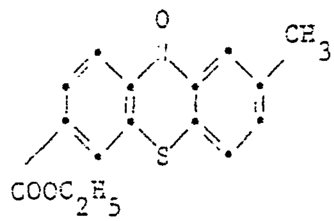

unter Gelblicht zugegeben und durch leichtes Erwärmen gelöst. Diese Lösung wird mittels eines Handrakels, der eine Nassdicke von 25 µm erlaubt, auf eine 100 µ dicke Polyesterfolie beschichtet und 3 Minuten bei 100 °C getrocknet. Man erhält eine homogene, transparente und schwach gelblich gefärbte, beschichtete Polyesterfolie, wobei die aufgetragene Polymerschicht eine Dicke von etwa 2-3 µm aufweist.

Beispiel 35

Maschinelle Beschichtung eines photographischen Trägers. Eine 15 %ige Polymerlösung, wie sie beispielsweise bei der Herstellung der erfindungsgemässen Polymeren in Lösung anfällt, wird mit dem entsprechenden Lösungsmittelgemisch Methyläthylketon/Methylcellosolve auf 9 % verdünnt und mit 5 % (bez. auf Polymergewicht) des in Beispiel 34 erwähnten Sensibilisators sowie mit 0,3 % eines fluorierten Netzmittels (FC 430® der Firma 3M Company) unter Gelblicht versetzt.

Diese Lösung wird unter Galblicht auf einer Versuchsbeschichtungsmaschine mittels dem Antauchverfahren auf Polyesterfolie, (Dicke : 100 µm ; Brite : 22 cm) beschichtet. Der Trockner (Länge : 4 m) hat eingangs eine Temperatur von 60 °C, ausgangs von 100 °C. Durch Verändern der Giessgeschwindigkeit (2 m/Minute-5 m/Minute) können Schichtdicken zwischen 1,5 bis 5 µm eingestellt werden. Man erhält gleichmässige, nicht klebende, gelblich gefärbte, lichtempfindliche Folien.

Beispiel 36

Latexbeschichtung

10 ml Latex, z. B. hergestellt nach den Beispielen 22 oder 27 (Feststoffgehalt 25,9 %), werden mit 7,3 ml Wasser auf 15 % Feststoffgehalt verdünnt, mit 130 mg der Verbindung der Formel

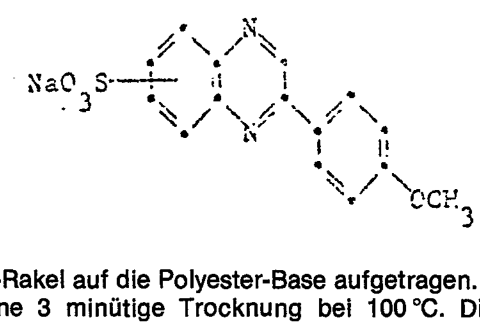

versetzt und mit einem 25-µm-Rakel auf die Polyester-Base aufgetragen. Einer 3 minütigen Vortrocknung bei Raumtemperatur folgt eine 3 minütige Trocknung bei 100 °C. Dicke der Trockenbeschichtung : 3,5 µm.

Die Beschichtung kann auch maschinell erfolgen wie in Beispeil 35 beschrieben.

Anwendungsbeispiele

Beispiel 37

Eine nach Beispiel 3 hergestellte Polymerlösung wird nach dem Verfahren nach Beispiel 35 maschinell auf einen Polyesterträger aufgetragen. Die derart hergestellten Filme werden auf einem Kopierapparat (Océ Helioprint 36®, 1 000 W-Metall-Halogenlampe im Abstand von 53 cm) im Kontakt mit einem Testkeil durch diesen hindurch während 30 Sekunden belichtet. Die belichteten Streifen werden für eine bestimmte Zeit in eine Entwicklerlösung der folgenden Zusammensetzung getaucht :

1,25 g des Farbstoffs der Formel (20),
1,25 g des Farbstoffs der Formel (21),
60 ml 0,2 M Tri-natriumphosphat in Wasser,
40 ml Aethylenglykol,
0,75 g 10 % Isooctylphenoxypolyäthoxyäthanol.

Dann wird 15 Sekunden in fliessendem Wasser (deionisiert) gewaschen und getrocknet. Die Resultate sind in der Tabelle 1 zusammengestellt. Man erhält orange gefärbte Bilder mit hoher optischer Dichte, einer Auflösung von > 120 Linien/mm und Rasterpunkten von hoher Qualität. Das Material kann daher als Kontaktfilm zur Belichtung einer Druckplatte verwendet werden.

Tabelle 1 (DMI-MA : MAS : AeA = 60 : 20 : 20)

| Giessgeschw. (m/Minute) | Entwicklungszeit (Sekunden) | Optische Dichte > 3,0 im angegebenen Bereich (nm) |
|---|---|---|
| 3 | 15 | 413 - 508 |
| (Schicht- | 30 | 395 - 523 |
| dicke: | | |
| ca. 2,5 µm) | 60 | 385 - 533 |

In analoger Weise wird mit einem nach Beispiel 2 und Beispiel 35 erhaltenen Film verfahren. Die Resultate sind in Tabelle 2 angeführt.

Tabelle 2 (DMI-MA : MAS = 70 : 30)

| Giessgeschw. (m/Minute) | Entwicklungszeit (Sekunden) | Optische Dichte > 3,0 im angegebenen Bereich (nm) |
|---|---|---|
| 3 | 15 | 395 - 525 |
| | 30 | 395 - 528 |
| | 60 | 382 - 535 |

Eine 15 %ige Lösung des Polymers gemäss Beispiel 29 in Methyläthylketon/Methylcellosolve 1 : 1 mit 5 % Sensibilisator des Beispiels 34 wird wie dort näher beschrieben auf eine Polyesterfolie aufgetragen. Der derart erhaltene, lichtempfindliche Film wurde, wie zuvor beschrieben, während 120 Sekunden durch

einen Testkeil belichtet und entwickelt. Man erhält ein orangefarbenes Bild, das 9 (von 10) Keilstufen zeigt.

Beispiel 38

Ein nach den Verfahren von Beispiel 1 und Beispiel 35 hergestellter lichtempfindlicher Film wird durch eine Mikrofilm-Vorlage, welche ein konventionelles Silberhalogenid-Negativ vom Kathodenstrahlbild eines Computers darstellt, wie in Beispiel 37 beschrieben, während 30 Sekunden belichtet. Die belichteten Filme werden während 15 Sekunden in eine Entwicklerlösung der folgenden Zusammensetzung getaucht:

1,0 g des Farbstoffs der Formel (22)
60 ml 0,1 M Tri-natriumphosphat in Wasser
40 ml Aethylenglykol
0,75 g 10 % Isooctylphenoxypolyäthoxyäthanol.

Dann wird 15 Sekunden in fliessendem Wasser gewaschen und getrocknet. Man erhält eine Kopie des Mikrofilm-Masters, die transparente Charaktere auf blauem Hintergrund aufweist und daher leicht lesbar ist.

Beispiel 39

Ein nach den Verfahren gemäss Beispiel 34 (Polymer gemäss Beispiel 16) hergestellter lichtempfindlicher Film wird weiterverarbeitet wie es im Beispiel 38 angegeben ist.

Der Film wird während 60 Sekunden belichtet und nachher für 20 Sekunden in eine Entwicklerlösung der folgenden Zusammensetzung getaucht:

1,75 g des Farbstoffs der Formel (20)
1,25 g des Farbstoffs der Formel (21)
100 ml 0,2 M Trinatriumphosphat in Wasser
0,075 g Isooctylphenoxypolyäthoxyäthanol
33 g Aethylenglykol.

Dann wird 15 Sekunden in fliessenden Wasser gewaschen und anschliessend getrocknet. Der Film ist im Wellenlängenbereich von 410 bis 570 nm mit einer optischer Dichte über 3 angefärbt und das Bild hat ein Auflösungsvermögen von über 150 Linien/mm.

Beispiel 40

Eine nach den Verfahren gemäss Beispiel 35 (Polymer gemäss Beispiel 16) hergestellter lichtempfindlicher Film wird wie im Beispiel 38 angegeben weiterverarbeitet. Der Film wird während 60 Sekunden belichtet und danach für 20 Sekunden in eine Entwicklerlösung der folgenden Zusammensetzung getaucht:

3,0 g des Farbstoffs der Formel (23)
1,0 g Natriumkarbonat
100 mg Isooctylphenoxypolyäthoxyäthanol
100 ml Wasser.

Dann wird 15 Sekunden im fliessenden Wasser gewaschen und anschliessend getrocknet. Man erhält eine Kopie des Mikrofilm-Masters mit einem tief gefärbten blauen Hintergrund, die leicht lesbar ist. Der Film hat eine Auflösung von über 330 Linien/mm.

Beispiel 41

Ein nach dem Verfahren gemäss Beispiel 35 (Polymer gemäss Beispiel 16) hergestellter lichtempfindlicher Film wird wie im Beispiel 38 beschrieben weiterverarbeitet. Der Film wird während 60 Sekunden belichtet und anschliessend für 20 Sekunden in eine schwarze Entwicklerlösung der folgenden Zusammensetzung getaucht:

0,1 g des Farbstoffs der Formel (20)
0,1 g des Farbstoffs der Formel (18)
0,5 g des Farbstoffs der Formel (24)
0,5 g des Farbstoffs der Formel (23)
1,0 g Natriumkarbonat
100 ml Wasser.

Der Film wird im fliessenden Wasser 15 Sekunden gewaschen und anschliessend getrocknet. Man erhält eine Kopie des Mikrofilm-Masters auf schwarzem Hintergrund. Die Kopie hat eine hohe Auflösung von über 330 Linien/nm.

### Beispiel 42

Ein nach den Verfahren gemäss Beispiel 34 hergestellter lichtempfindlicher Film (Polymer gemäss Beispiel 25) wird wie im Beispiel 38 beschrieben weiterverarbeitet.

Der Film wird während 30 Sekunden belichtet und nachher 60 Sekunden in eine blaue Entwicklerlösung der folgenden Zusammensetzung getaucht :

3,0 g des Farbstoffs der Formel (25)
2,0 g konz. Essigsäure
30 g Aethylenglykol
65 ml Wasser.

Der Film wird 15 Sekunden im fliessenden Wasser gewaschen und anschliessend getrocknet. Die Kopie weist transparente Charaktere auf blauem Hintergrund auf.

### Beispiel 43

Eine nach Beispiel 3 hergestellte Polymerlösung wird mit 8 % (bez. auf Polymergewicht) des in Beispiel 34 erwähnten Sensibilisators sowie mit 0,3 % des in Beispiel 31 erwähnten fluorierten Netzmittels unter Gelblicht versetzt, auf 7 % Feststoffgehalt verdünnt (mit MEK/MCS 4 : 1) und nach dem Verfahren nach Beispiel 35 maschinell auf einen Polyesterträger (0,100 µm Dicke) geschichtet. Giessgeschwindigkeit 3 m/min, Dicke der trockenen Schicht ca. 2 µm. Nach 30 Sekunden Kontaktbelichtung durch eine Testvorlage wird der Film in einem Prozessor, der 2 Bäder enthält, entwickelt. Das erste Bad enthält eine Entwicklerlösung der folgenden Zusammensetzung :

1,50 g des Farbstoffes der Formel (20)
2,50 g des Farbstoffes der Formel (21)
100 ml 0,25 M Tri-natriumphosphat in Wasser
0,75 g 10 % Isooctylphenoxypolyäthoxiäthanol.

Im zweiten Bad zirkuliert Wasser. Anschliessend daran befindet sich ein Heisslufttrockner. Der Film wird mittels Gummiwalzen durch die Bäder geführt. Die Verweilzeit in den beiden Bäder beträgt je ca. 7 Sekunden. Man erhält orange gefärbte Bilder mit hoher optischer Dichte (> 3,0), die keinen Schleier aufweisen und mechanisch nicht beschädigt sind.

### Beispiel 44

Handbeschichtung eines photographischen Trägers mit einem Copolymeren mit basischen Gruppen

530 mg des Polymeren gemäss Beispiel (33) und 53 mg eines wasserlöslichen Sensibilisators der Formel

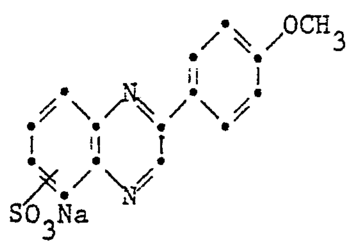

werden unter Gelblicht in 4,30 g Wasser gelöst. Diese Lösung wird mittels eines 25-µm-Handrakels auf eine 100 µ Dicke Polyesterfolie beschichtet und 3 Minuten bei 100 °C getrocknet, die homogene und transparente aufgetragen Polymerschicht weist eine Dicke von etwa 2-3 µm auf.

Die derart hergestellten Filme werden gemäss Beispiel 37 belichtet. Die belichteten Streifen werden für 20 Sekunden in eine 5 %ige wässrige Lösung der Verbindung der Formel

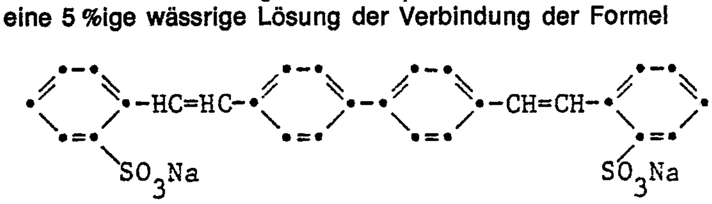

getaucht. Dann wird 15 Sekunden in fliessendem Wasser gewaschen und getrocknet. Man erhält Bilder, die bei $\lambda_{max}$ = 360 mm eine optische Dichte von 2,3 haben.

Beispiel 45

Vergleichsbeispiel

Ein nach den Verfahren gemäss Beispiel 35 (Polymer gemäss Beispiel 1) hergestellter, lichtempfindlicher Film wird durch eine Vorlage wie im Beispiel 37 beschrieben 30 Sekunden belichtet und nach 3 Methoden entwickelt :

(A) in einer erfindungsgemässen alkalischen Farbstofflösung wie in Beispiel 37 beschrieben.

(B) nach einem üblichen Verfahren, wobei folgende Verfahrensschritte notwendig sind :

30 Sekunden Eintauchen in eine wässrige 5 %ige Natriumkarbonatlösung
5 Sekunden spülen mit Wasser
30 Sekunden Eintauchen in eine wässrige 2 %ige Lösung des Farbstoffs der Formel (27) (pH 4.5)
30 Sekunden mit Wasser spülen, trocknen.

(C) 30 Sekunden Eintauchen in eine wässrige 0,2 molare Trinatriumphosphatlösung. Weiterverarbeitung gemäss (B).

Resultat

Methode (A) : Gut haftende, orange gefärbte Bilder mit hoher optischer Dichte und Auflösung.
(B) : Bei der Zwischenspülung mit Wasser starke Quellung des Polymereliefs, rot gefärbte Bilder von schlechter Qualität, Bildpartien zum Teil abgelöst.
(C) : Bei der Zwischenspülung mit Wasser quillt das Relief sehr stark und löst sich von der Trägerfolie ab. Kein Bild.

**Ansprüche**

1. Verfahren zur Herstellung von photographischen Abbildungen unter Verwendung eines lichtempfindlichen Aufzeichnungsmaterials, das auf einem Träger lichtvernetzbare Copolymere mit einem durchschnittlichen Molekulargewicht von $10^3$ bis $10^6$ enthält, deren Seitenketten lichtaktive Maleinimidgruppierungen aufweisen, wobei das Copolymer

(1) mindestens 10 Gew.-%, bezogen auf die Gesamtmenge der Comonomeren, eines Acrylsäure- oder Methacrylsäureesters, Acrylsäure- oder Methacrylsäureamides oder Vinylätherderivates, das mindestens eine Maleinimidgruppe der Formel

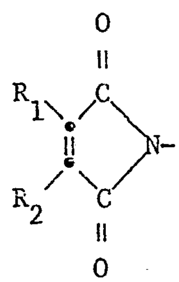

enthält, worin $R_1$ und $R_2$ je Alkyl mit 1 bis 4 Kohlenstoffatomen sind oder $R_1$ und $R_2$ zusammen mit den Kohlenstoffatomen, mit denen sie verbunden sind, einen 5- oder 6-gliedrigen carbocyclischen Ring bilden,

(2) mindestens 18 Gew.-%, bezogen auf die Gesamtmenge der Comonomeren, eines Dialkylaminogruppen tragenden Carbonsäurederivates einer α,β-ungesättigten Carbonsäure oder einer stickstoffheterocyclischen Vinylverbindung, und gegebenenfalls

(3) mindestens ein weiteres, äthylenisch ungesättigtes Comonomer, das von (1) und (2) verschieden ist, enthält,

dadurch gekennzeichnet, dass man das bildmässig belichtete Material mit einer sauren, wässrigen oder

wässrig-organischen Lösung, die einen anionischen Farbstoff enthält, entwickelt, anschliessend auswäscht und trocknet.

2. Verfahren zur Herstellung von photographischen Abbildungen unter Verwendung eines lichtempfindlichen Aufzeichnungsmaterials, das auf einem Träger lichtvernetzbare, Carboxylgruppen enthaltende Copolymere mit einem durchschnittlichen Molekulargewicht von $10^3$ bis $10^6$ aus mindestens 10 Gew.-% Maleinsäureanhydrid, bezogen auf die Gesamtmenge der Comonomeren, und $\alpha,\beta$-ungesättigten Comonomeren enthält, wobei die Seitenketten der Copolymere lichtaktive Maleinimidgruppierungen der Formel

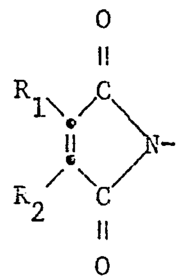

enthalten, worin $R_1$ und $R_2$ je Alkyl mit 1 bis 4 Kohlenstoffatomen sind oder $R_1$ und $R_2$ zusammen mit den Kohlenstoffatomen, mit denen sie verbunden sind, einen 5- oder 6-gliedrigen carbocyclischen Ring bilden, dadurch gekennzeichnet, dass man das bildmässig belichtete Material mit einer alkalischen, wässrigen oder wässrig-organischen Lösung, die einen kationischen Farbstoff enthält, entwickelt, anschliessend auswäscht und trocknet.

3. Verfahren zur Herstellung von photographischen Abbildungen unter Verwendung eines Aufzeichnungsmaterials, das auf einem Träger eine Schicht aus mindestens einem lichtvernetzbaren Copolymer mit einem durchschnittlichen Molekulargewicht von $10^3$ bis $10^6$ enthält, dessen Seitenketten lichtaktive Maleinimidgruppierungen aufweisen, wobei das Copolymer

(1) mindestens 10 Gewichtsprozent, bezogen auf die Gesamtmenge der Comonomeren eines (Meth)acrylsäureester-, (Meth)acrylsäureamid- oder Vinylätherderivates, das mindestens eine Maleinimidgruppe der Formel

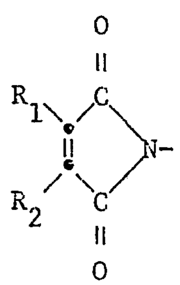

(1)

enhtält, worin $R_1$ und $R_2$ je Alkyl mit 1 bis 4 Kohlenstoffatomen sind oder $R_1$ und $R_2$ zusammen mit den Kohlenstoffatomen, mit denen sie verbunden sind, einen 5- oder 6-gliedrigen carbocyclischen Ring bilden,

(2) mindestens 18 Gew.-%, bezogen auf die Gesamtmenge der Comonomeren, eines saure Gruppen aufweisenden, äthylenisch ungesättigten Comonomers aus der Gruppe Acrylsäure, Methacrylsäure, Crotonsäure, Maleinsäure, Fumarsäure, Itaconsäure, Vinylsulfonsäure und deren Salze, Styrolsulfonsäure, 2-Sulfoäthyl-methacrylat oder ein Phthalsäure(meth)acrylathalbester und gegebenenfalls

(3) mindestens ein weiteres, äthylenisch ungesättigtes Comonomer, das von den Comonomeren (1) und (2) verschieden ist, enthält,

dadurch gekennzeichnet, dass man das bildmässig belichtete Material mit einer alkalischen, wässrigen oder wässrig-organischen Lösung, die einen kationischen Farbstoff enthält, entwickelt, anschliessend auswäscht und trocknet.

4. Lichtvernetzbares Copolymer, dessen Seitenketten lichtaktive Maleinimidgruppierungen aufweisen, mit einem durchschnittlichen Molekulargewicht von $10^3$ bis $10^6$ aus

(1) mindestens 10 Gew.-%, bezogen auf die Gesamtmenge der Comonomeren eines (Meth)acrylsäureester-, (Meth)acrylsäureamid- oder Vinylätherderivates, das mindestens eine Maleinimidgruppe der Formel

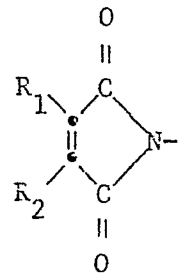

enthält, worin $R_1$ und $R_2$ je Alkyl mit 1 bis 4 Kohlenstoffatomen sind oder $R_1$ und $R_2$ zusammen mit den Kohlenstoffatomen, mit denen sie verbunden sind, einen 5- oder 6-gliedrigen carbocyclischen Ring bilden,

(2) eines saure Gruppen aufweisenden, äthylenisch ungesättigten Comonomer aus der Gruppe Acrylsäure, Methacrylsäure, Crotonsäure, Maleinsäure, Fumarsäure, Itaconsäure, 2-Sulfoäthylmethacrylat, Vinylsulfonsäure und deren Salze, Styrolsulfonsäure oder ein Phthalsäure(meth)acrylathalbester, und gegebenenfalls

(3) mindestens ein weiteres, äthylenisch ungesättigtes Comonomer, das von den Comonomeren (1) und (2) verschieden ist, enthält,

dadurch gekennzeichnet, dass das Comonomer (2) in einer Menge von mindestens 18 Gew.-%, bezogen auf die Gesamtmenge der Comonomeren, zugegen ist.

5. Lichtvernetzbares Copolymer nach Anspruch 4, dadurch gekennzeichnet, dass es 10 bis 82 Gew.-% der Komponente (1), 18 bis 50 Gew.-% der Komponente (2) und 0 bis 72 Gew.-% der Komponente (3) enthält.

6. Lichtvernetzbares Copolymer nach Anspruch 4, dadurch gekennzeichnet, dass das Comonomer (1) den Formeln

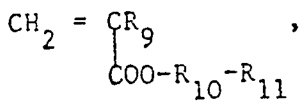 , (7)

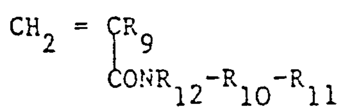 oder (8)

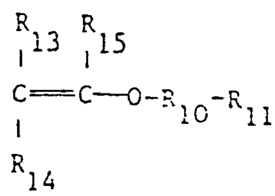 (9)

entspricht, worin $R_9$ Wasserstoff oder Methyl, $R_{10}$ geradkettiges oder verzweigtes Alkylen mit 1 bis 12 Kohlenstoffatomen oder Cycloalkylen mit 5 oder 6 Kohlenstoffatomen, $R_{11}$ eine Maleinimidgruppierung der Formel

(10) 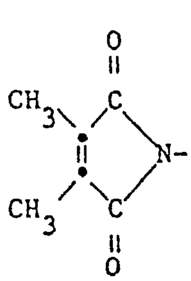 , (11) 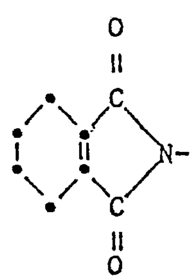 oder (12) 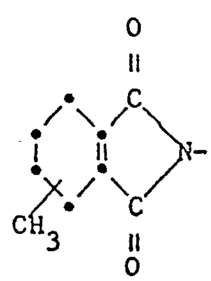

und $R_{12}$ Wasserstoff oder Alkyl mit 1 bis 6 Kohlenstoffatomen ist und $R_{13}$, $R_{14}$ und $R_{15}$ je Wasserstoff, Halogen, Cyano oder Alkyl mit 1 bis 6 Kohlenstoffatomen sind.

7. Lichtvernetzbares Copolymer nach Anspruch 4, dadurch gekennzeichnet, dass das Comonomer (2) Carboxylgruppen enthält.

8. Lichtvernetzbares Copolymer nach Anspruch 4, dadurch gekennzeichnet, dass das Comonomer (3) ein Alken, Vinyl- oder Vinylidenhalogenid, (Meth)acrylnitril, Ester oder Amide einer α-ungesättigten Säure, eine aromatische oder heterocyclische Vinylverbindung, ein Vinylester oder -äther oder ein Vinylketon ist.

9. Lichtvernetzbares Copolymer nach Anspruch 8, dadurch gekennzeichnet, dass das Comonomer (3) ein (Meth)acrylsäurealkyl- oder -hydroxyalkylester ist.

10. Lichtempfindliches Aufzeichnungsmaterial, das auf einem Träger eine Schicht aus mindestens einem lichtvernetzbaren Copolymer enthält, dadurch gekennzeichnet, dass das Copolymer ein solches gemäss Ansprüchen 4 bis 9 ist.

11. Aufzeichnungsmaterial nach Anspruch 10, dadurch gekennzeichnet, dass es in der Schicht mit dem lichtvernetzbaren Polymeren zusätzlich einen Sensibilisator für die Photovernetzung sowie gegebenenfalls Farbstoffe, Pigmente und/oder Füllstoffe enthält.

12. Aufzeichnungsmaterial nach Anspruch 10, dadurch gekennzeichnet, dass der Träger ein transparenter Träger ist, auf den in direktem Kontakt oder mittels einer Substrierschicht die Schicht mit den lichtvernetzbaren Polymeren aufgebracht ist.

**Claims**

1. A process for the production of a photographic image using a ligth-sensitive recording material which contains, on a support, photocrosslinkable copolymers having an average molecular weight of $10^3$ to $10^6$ and the side-chains of which contain photoactive maleimide groupings, which copolymer contains

(1) at least 10% by weight, based on the total weight of the comonomers, of an acrylate or methacrylate, acrylamide or methacrylamide, or of a vinyl ether derivative, which contains at least one maleimide group of the formula

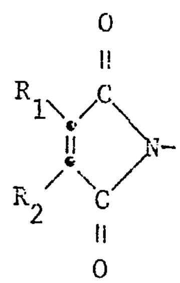

wherein each of $R_1$ and $R_2$ is $C_1$-$C_4$ alkyl, or $R_1$ and $R_2$, together with the carbon atoms to which they are attached, form a 5- or 6-membered carbocyclic ring,

(2) a carboxylic acid derivative of an α,β-unsaturated carboxylic acid or of an N-heterocyclic vinyl compound, said derivative containing dialkylamino grups, and optionally

(3) at least one further ethylenically unsaturated comonomer which is different from (1) and (2),

which process comprises developing the material which has been exposed imagewise with an acid, aqueous or aqueous-organic solution, and then washing off and drying.

2. A process for the production of a photographic image using a light-sensitive recording material which contains, on a support, copolymers having an average molecular weight of $10^3$ to $10^6$, said copolymers containing carboxyl groups and being obtained from at least 10% by weight of maleic anhydride, based on the total amount of the comonomers, and from α,β-unsaturated comonomers, the side chains of said copolymers containing photoactive maleimide groupings of the formula

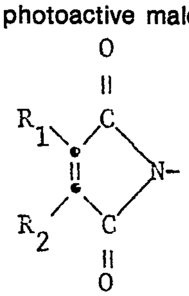

wherein each of $R_1$ and $R_2$ is $C_1$-$C_4$ alkyl, or $R_1$ and $R_2$, together with the carbon atoms to which they are attached, form a 5- or 6-membered carbocyclic ring, which process comprises developing the imagewise exposed material with an alkaline, aqueous or aqueous-organic solution which contains a cationic dye, and then washing off and drying.

3. A process for the production of a photographic image using a recording material which contains, on a support, one layer of at least one photocrosslinkable copolymer having an average molecular weight of $10^3$ to $10^6$, the side chains of which copolymer contain photoactive maleimide groupings, which copolymer contains

(1) at least 10 % by weight, based on the total amount of the comonomers, of a (meth)acrylate, (meth)acrylamide or vinyl ether derivative which contains at least one maleimide group of the formula

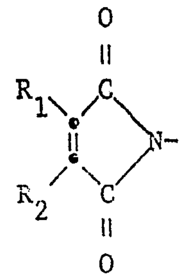

(1)

wherein each of $R_1$ and $R_2$ is $C_1$-$C_4$ alkyl, or $R_1$ and $R_2$, together with the carbon atoms to which they are attached, form a 5- or 6-membered carbocyclic ring,

(2) at least 18 % by weight, based on the total amount of the comonomers, of an ethylenically unsaturated comonomer selected from the group consisting of acrylic acid, methacrylic acid, crotonic acid, maleic acid, fumaric acid, itaconic acid, vinylsulfonic acid and the salts thereof, styrenesulfonic acid, 2-sulfoethylmethacrylate or a (meth)acrylate hemiester of phthalic acid, which comonomer contains acid groups, and optionally

(3) at least one further ethylenically unsaturated comonomer which is different from the comonomers (1) and (2),

which process comprises developing the imagewise exposed material with an alkaline, aqueous or aqueous-organic solution which contains a cationic dye, and then washing off and drying.

4. A photocrosslinkable copolymer, the side chains of which contain photoactive maleimide groupings, having an average molecular weight of $10^3$ to $10^6$, said copolymer comprising

(1) at least 10 % by weight, based on the total amount of the comonomers of a (meth)acrylate, (meth)acrylamide or vinyl ether derivative which contains at least one maleimide group of the formula

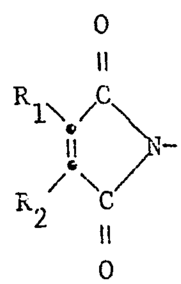

wherein each of $R_1$ and $R_2$ is $C_1$-$C_4$ alkyl, or $R_1$ and $R_2$, together with the carbon atoms to which they are attached, form a 5- or 6-membered carbocyclic ring,

(2) an ethylenically unsaturated comonomer selected from the group consisting of acrylic acid, methacrylic acid, crotonic acid, maleic acid, fumaric acid, itaconic acid, 2-sulfoethylmethacrylate, vinylsulfonic acid and the salts thereof, styrenesulfonic acid or a (meth)acrylate hemiester of phthalic acid, and optionally

(3) at least one further ethylenically unsaturated comonomer which is different from the comonomers (1) and (2),

said comonomer (2) being present in an amount of at least 18 % by weight, based on the total amount of the comonomers.

5. A photocrosslinkable copolymer according to claim 4, which contains 10 to 82 % by weight of component (1), 18 to 50 % by weight of component (2) and 0 to 72 % by weight of component (3).

6. A photocrosslinkable copolymer according to claim 4, wherein the comonomer (1) has the formula

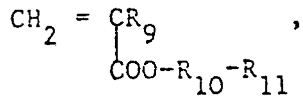 (7)

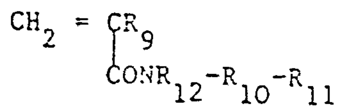 or (8)

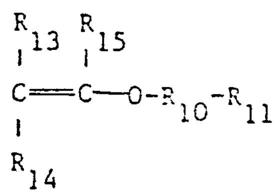 (9)

in which $R_9$ is hydrogen or methyl, $R_{10}$ is straight-chain or branched $C_1$-$C_{12}$ alkylene or $C_5$-$C_6$ cycloalkylene, $R_{11}$ is a maleimide grouping of the formula

(10) 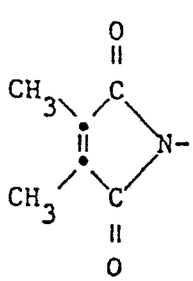 , (11) 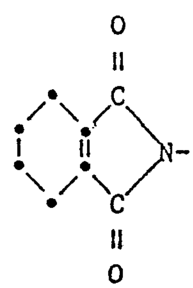 or (12) 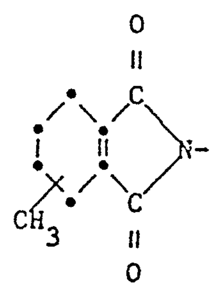

and $R_{12}$ is hydrogen or $C_1$-$C_6$ alkyl and $R_{13}$, $R_{14}$ and $R_{15}$ are each hydrogen, halogen, cyano or $C_1$-$C_6$ alkyl.

7. A photocrosslinkable copolymer according to claim 4, wherein the comonomer (2) contains carboxyl groups.

8. A photocrosslinkable copolymer according to claim 4, wherein the comonomer (3) is an alkene, a vinyl halide or vinylidene halide, (meth)acrylonitrile, an ester or amide of an α,β-unsaturated acid, an aromatic or heterocyclic vinyl compound, a vinyl ester or vinyl ether or a vinyl ketone.

9. A photocrosslinkable polymer according to claim 8, wherein the comonomer (3) is an alkyl (meth)acrylate or a hydroxyalkyl (meth)acrylate.

10. A light-sensitive recording material which contains on a support, one layer of at least one photocrosslinkable copolymer according to any one of claims 4 to 9.

11. A recording material according to claim 10, which additionally contains, in the layer with the photocrosslinkable polymer, a sensitiser for photocrosslinking and also, optionally, dyes, pigments and/or fillers.

12. A recording material according to claim 10, wherein the support is a transparent support to which the layer containing the photocrosslinkable polymers is applied in direct contact.

**Revendications**

1. Procédé pour réaliser des images photographiques au moyen d'une matière d'enregistrement photosensible comprenant, déposé sur un support, un copolymère photoréticulable dont la masse

moléculaire moyenne est comprise entre $10^3$ et $10^6$ et dont les chaînes latérales portent des radicaux maléimido photo-actifs, le copolymère en question contenant

(1) au moins 10 % en poids, par rapport à la quantité totale des comonomères, d'un ester acrylique ou méthacrylique, d'un acrylamide ou d'un méthacrylamide ou d'un éther vinylique, qui renferme au moins un radical maléimido répondant à la formule

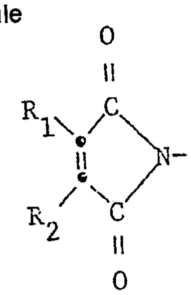

dans laquelle $R_1$ et $R_2$ représentent chacun un alkyle contenant de 1 à 4 atomes de carbone, ou $R_1$ et $R_2$ forment ensemble, et avec les atomes de carbone auxquels ils sont liés, un noyau carbocyclique à 5 ou 6 maillons,

(2) un dérivé d'acide carboxylique insaturé en α,β et porteur d'un radical dialkylamino ou un composé vinylique à hétérocyclique azoté, et éventuellement

(3) au moins un autre comonomère éthylénique différent de (1) et de (2),

procédé caractérisé en ce qu'on développe la matière, après qu'elle a été exposée à la lumière conformément à une image, au moyen d'une solution aqueuse ou aqueuse-organique, acide, qui contient un colorant anionique, puis on la lave et on la sèche.

2. Procédé pour réaliser des images photographiques au moyen d'une matière d'enregistrement photosensible comprenant, déposés sur un support, des copolymères photoréticulables qui portent des radicaux carboxy, dont la masse moléculaire moyenne est comprise entre $10^3$ et $10^6$ et qui sont constitués d'au moins 10 % en poids d'anhydride maléique, par rapport à la quantité totale des comonomères, et de comonomères insaturés en α,β, les chaînes latérales desdits copolymères renfermant des radicaux maléimido photo-actifs de formule

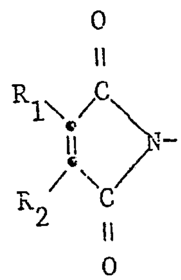

(dans lesquels $R_1$ et $R_2$ représentent chacun un alkyle contenant de 1 à 4 atomes de carbone, ou $R_1$ et $R_2$ forment ensemble, et avec les atomes de carbone auxquels ils sont liés, un noyau carbocyclique à 5 ou 6 maillons), procédé caractérisé en ce qu'on développe la matière, après qu'elle a été exposée à la lumière selon une image, au moyen d'une solution aqueuse ou aqueuse-organique, alcaline, qui renferme un colorant cationique, puis on la lave et on la sèche.

3. Procédé pour réaliser des images photographiques au moyen d'une matière d'enregistrement comprenant, déposée sur un support, une couche d'au moins un copolymère photoréticulable dont la masse moléculaire moyenne est comprise entre $10^3$ et $10^6$ et dont les chaînes latérales portent des radicaux maléimido photo-actifs, ledit polymère renfermant

(1) au moins 10 % en poids, par rapport à la quantité totale des comonomères, d'un ester acrylique ou méthacrylique, d'un acrylamide ou d'un méthacrylamide ou d'un éther vinylique, qui contient au moins un radical maléimido répondant à la formule

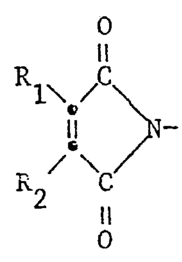

(1)

dans laquelle $R_1$ et $R_2$ représentent chacun un alkyle contenant de 1 à 4 atomes de carbone, ou $R_1$ et $R_2$ forment ensemble, et avec les atomes de carbone auxquels ils sont liés, un noyau carbocyclique à 5 ou 6 maillons,

(2) au moins 18 % en poids, par rapport à la quantité totale des comonomères, d'un comonomère éthylénique porteur d'un radical acide, pris dans l'ensemble constitué par l'acide acrylique, l'acide méthacrylique, l'acide crotonique, l'acide maléique, l'acide fumarique, l'acide itaconique, l'acide éthylène-sulfonique et ses sels, l'acide styrène-sulfonique, le méthacrylate de sulfo-2 éthyle ou les hémi-esters phtaliques contenant un radical acryloyloxy ou méthacryloyloxy, et éventuellement

(3) au moins un autre comonomère éthylénique différent des comonomères (1) et (2),

procédé caractérisé en ce qu'on développe la matière, après qu'elle a été exposée à la lumière selon une image, au moyen d'une solution aqueuse ou aqueuse-organique, alcaline, qui contient un colorant cationique, puis on la lave et on la sèche.

4. Copolymère photoréticulable dont les chaînes latérales portent des radicaux maléimido photoactifs, qui a une masse moléculaire moyenne de $10^3$ à $10^6$ et qui est constitué

(1) d'au moins 10 % en poids, par rapport à la quantité totale des comonomères, d'un ester acrylique ou méthacrylique, d'un acrylamide ou méthacrylamide ou d'un éther vinylique, qui contient au moins un radical maléimido répondant à la formule

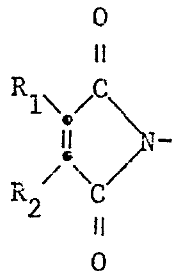

dans laquelle $R_1$ et $R_2$ représentent chacun un alkyle en $C_1$-$C_4$, ou $R_1$ et $R_2$ forment ensemble, et avec les atomes de carbone auxquels ils sont liés, un noyau carbocyclique pentagonal ou hexagonal,

(2) d'un comonomère éthylénique porteur d'un radical acide, pris dans l'ensemble constitué par l'acide acrylique, l'acide méthacrylique, l'acide crotonique, l'acide maléique, l'acide fumarique, l'acide itaconique, le méthacrylate de sulfo-2 éthyle, l'acide éthylène-sulfonique et ses sels, l'acide styrène-sulfonique et les hémi-esters phtaliques porteurs d'un radical acryloyloxy ou méthacryloyloxy, et éventuellement

(3) d'au moins un comonomère éthylénique supplémentaire qui est différent des comonomères (1) et (2),

copolymère caractérisé en ce que le comonomère (2) est présent en une quantité d'au moins 18 % en poids par rapport à la quantité totale des comonomères.

5. Copolymère photoréticulable selon la revendication 4, caractérisé en ce qu'il contient de 10 à 82 % en poids de la composante (1), de 18 à 50 % en poids de la composante (2) et de 0 à 72 % en poids de la composante (3).

6. Copolymère photoréticulable selon la revendication 4, caractérisé en ce que le comonomère (1) répond à l'une des formules suivantes :

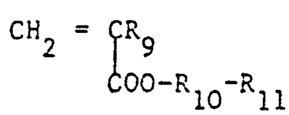 ,

(7)

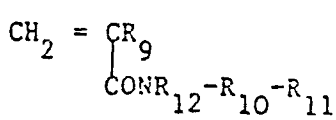

et

(8)

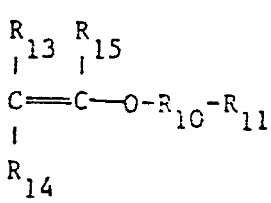

(9)

dans lesquelles $R_9$ représente l'hydrogène ou un méthyle, $R_{10}$ représente un radical alkylène, linéaire ou ramifié, contenant de 1 à 12 atomes de carbone ou un radical cyclo-alkylène contenant 5 ou 6 atomes de carbone, $R_{11}$ représente un radical maléimido de formule

(10) 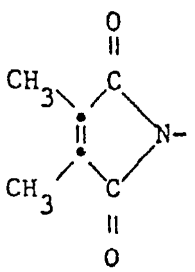 , (11) 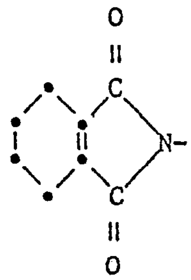 ou (12) 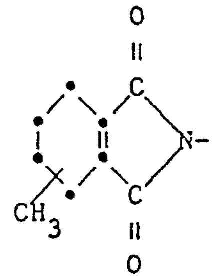

$R_{12}$ représente l'hydrogène ou un alkyle contenant de 1 à 6 atomes de carbone et $R_{13}$, $R_{14}$ et $R_{15}$ représentent chacun l'hydrogène, un halogène, un cyano ou un alkyle en $C_1$-$C_6$.

7. Copolymère photoréticulable selon la revendication 4, caractérisé en ce que le comonomère (2) contient des radicaux carboxy.

8. Copolymère photoréticulable selon la revendication 4, caractérisé en ce que le comonomère (3) est un alcène, un halogénure de vinyle ou de vinylidène, l'acrylonitrile ou le méthacrylonitrile, un ester ou amide d'acide insaturé en α, un composé vinylique aromatique ou hétérocyclique, un ester vinylique, un éther vinylique ou une vinyl-cétone.

9. Copolymère photoréticulable selon la revendication 8, caractérisé en ce que le comonomère (3) est un acrylate ou méthacrylate d'alkyle ou d'hydroxyalkyle.

10. Matière d'enregistrement photosensible comprenant, déposée sur un support, une couche d'au moins un copolymère photoréticulable, matière caractérisée en ce que le copolymère est un copolymère selon l'une quelconque des revendications 4 à 9.

11. Matière d'enregistrement selon la revendication 10, caractérisée en ce qu'elle contient en outre, dans la couche comportant le polymère photoréticulable, un sensibilisateur pour la photoréticulation et éventuellement des colorants, des pigments et/ou des charges.

12. Matière d'enregistrement selon la revendication 10, caractérisée en ce que le support est un support transparent sur lequel on a appliqué la couche comportant le polymère photoréticulable, directement ou à l'aide d'une couche intermédiaire.